(19)

(11) **EP 4 482 042 B1**

(12) **EUROPEAN PATENT SPECIFICATION**

(45) Date of publication and mention of the grant of the patent: **01.04.2026 Bulletin 2026/14**

(21) Application number: **22932565.9**

(22) Date of filing: **21.03.2022**

(51) International Patent Classification (IPC): ***H04B 7/00*** *(2006.01)* ***H04B 1/04*** *(2006.01)*

(52) Cooperative Patent Classification (CPC): **H04B 1/40; H04B 1/0483**

(86) International application number: **PCT/CN2022/082120**

(87) International publication number: **WO 2023/178496 (28.09.2023 Gazette 2023/39)**

(54) **COMMUNICATION DEVICE AND OPERATION METHOD THEREFOR**

KOMMUNIKATIONSVORRICHTUNG UND BETRIEBSVERFAHREN DAFÜR

DISPOSITIF DE COMMUNICATION ET SON PROCÉDÉ DE FONCTIONNEMENT

(84) Designated Contracting States: **AL AT BE BG CH CY CZ DE DK EE ES FI FR GB GR HR HU IE IS IT LI LT LU LV MC MK MT NL NO PL PT RO RS SE SI SK SM TR**

(43) Date of publication of application: **25.12.2024 Bulletin 2024/52**

(73) Proprietor: **Huawei Technologies Co., Ltd. Shenzhen, Guangdong 518129 (CN)**

(72) Inventors:
- **GUO, Wanyi Shenzhen, Guangdong 518129 (CN)**
- **GUO, Dongdong Shenzhen, Guangdong 518129 (CN)**
- **GAO, Peng Shenzhen, Guangdong 518129 (CN)**

(74) Representative: **Gill Jennings & Every LLP The Broadgate Tower 20 Primrose Street London EC2A 2ES (GB)**

(56) References cited:
**CN-A- 101 478 291**
**CN-A- 101 917 167**
**US-A- 5 438 684**
**US-A1- 2010 311 339**
**US-A1- 2013 070 772**
**US-A1- 2019 081 399**

Note: Within nine months of the publication of the mention of the grant of the European patent in the European Patent Bulletin, any person may give notice to the European Patent Office of opposition to that patent, in accordance with the Implementing Regulations. Notice of opposition shall not be deemed to have been filed until the opposition fee has been paid. (Art. 99(1) European Patent Convention).

EP 4 482 042 B1

## Description

### TECHNICAL FIELD

This application relates to the field of wireless communication technologies, and in particular, to a communication device and an operating method thereof.

### BACKGROUND

A power divider/combiner is a device configured to mutually convert a single path of radio frequency signal and a plurality of paths of radio frequency signals. The power divider/combiner may divide one path of radio frequency signal into a plurality of paths of equally divided or unequally divided radio frequency signals. In this case, the power divider/combiner may be referred to as a power divider. The power divider/combiner may alternatively combine a plurality of paths of radio frequency signals into one path of radio frequency signal. In this case, the power divider/combiner may be referred to as a power combiner.

However, power waste is present in a current power divider and power combiner. When the power divider/combiner is used in a communication device, a large loss of the communication device is caused. US 2019/081399 A1 discloses a signal processing circuit a signal processing circuit including a first set of ports, a third port, a first path, a second path and a first transistor. US 2010/311339 A1 discloses a system for coexistence between wireless communication modules sharing an antenna. CN 101478291 A discloses a high-power amplifier

### SUMMARY

Embodiments of this application provide a communication device and an operating method thereof, to reduce a loss of the communication device.

To achieve the foregoing objective, the following technical solutions are used in this application.

According to a first aspect, an embodiment of this application provides a communication device according to cliam 1.

The power divider/combiner in the communication device provided in this embodiment of this application includes the mode tuning circuit. The mode tuning circuit controls whether the first signal transmission network is connected, to achieve effect of tuning the power divider/combiner to enter the first mode (a dual-connected mode in which both the first signal transmission network and the second signal transmission network are connected) or enter the second mode (a direct-connected mode in which only the second signal transmission network is connected). In this way, the power divider/combiner may be configured to be in the dual-connected mode or the direct-connected mode based on an actual application scenario. If the first signal transmission network and the second signal transmission network do not need to be both connected, the power divider/combiner may be tuned to the direct-connected mode. In the direct-connected mode, power waste on an unused branch can be avoided, and an insertion loss of the power divider/combiner can be reduced.

In a possible implementation, the mode tuning circuit is further coupled to the second signal transmission network; and the operating mode of the power divider/combiner further includes a third mode, where the third mode is that only the first signal transmission network is connected. The mode tuning circuit may further control whether the second signal transmission network is connected, to achieve effect of tuning whether the power divider/combiner enters the third mode (a direct-connected mode in which only the first signal transmission network is connected), so as to increase a mode type of the power divider/combiner.

In a possible implementation, the power divider/combiner further includes an isolation circuit, the isolation circuit is coupled between the first signal transmission network and the second signal transmission network, and the mode tuning circuit is further coupled to the isolation circuit. The isolation circuit is disposed, and the isolation circuit performs an isolation function, so that isolation between the first dividing port and the second dividing port can be increased, and signal leakage can be reduced.

In a possible implementation, the mode tuning circuit further includes a second switch, and the second switch is coupled to the second signal transmission network and is configured to control whether the second signal transmission network is connected. This is an implementation with a simple structure.

In a possible implementation, the first signal transmission network further includes a first capacitor, a first end of the first capacitor is coupled to the first end of the first inductor, and a second end of the first capacitor is coupled to a ground end. The second signal transmission network further includes a second capacitor, a first end of the second capacitor is coupled to a first end of a third inductor, and a second end of the second capacitor is coupled to the ground end. The first capacitor and the second capacitor are used as tuning capacitors. The first capacitor and the first inductor resonate together, and the second capacitor and the third inductor resonate together, so that a transformer operates in a required frequency band, and an operating frequency of the transformer can be tuned through tuning.

In a possible implementation, the power divider/combiner further includes a third capacitor, and two ends of the third capacitor are coupled to the first end of the first inductor and the first end of the third inductor respectively. The first inductor and the third inductor on the two transformer networks on a first branch and a second branch share a same tuning capacitor (the third capacitor), so that a structure of the power divider/combiner can be simplified.

In a possible implementation, the first signal transmission network further includes a fourth capacitor, and the second signal transmission network further includes a fifth capacitor. The fourth capacitor is connected in parallel to the second inductor, and the fifth capacitor is connected in parallel to the fourth inductor. The fourth capacitor and the fifth capacitor are used as tuning capacitors. The fourth capacitor and the second inductor resonate together, and the fifth capacitor and the fourth inductor resonate together, so that the transformer operates in the required frequency band, and the operating frequency of the transformer can be tuned through tuning.

In a possible implementation, two ends of the first switch in the mode tuning circuit are correspondingly coupled to the first positive dividing differential terminal and the first negative dividing differential terminal. This is an implementation with a simple structure.

In a possible implementation, two ends of the second switch in the mode tuning circuit are correspondingly coupled to the second positive dividing differential terminal and the second negative dividing differential terminal. This is an implementation with a simple structure.

In a possible implementation, the isolation circuit includes a first isolation resistor and a second isolation resistor, and the mode tuning circuit further includes a third switch and a fourth switch. The first isolation resistor and the third switch are coupled in series between the first positive dividing differential terminal and the second positive dividing differential terminal. The second isolation resistor and the fourth switch are coupled in series between the first negative dividing differential terminal and the second negative dividing differential terminal. The first isolation resistor and the second isolation resistor are disposed, and both the first isolation resistor and the second isolation resistor perform an isolation function, so that isolation between the two ports of the first dividing port and the second dividing port can be increased (or understood as that signal leakage is near zero). The third switch and the fourth switch are configured to match the first switch and the second switch to tune an operating mode of the power divider/combiner in an operating process of the power divider/combiner.

In a possible implementation, the isolation circuit includes a third isolation resistor, and the mode tuning circuit further includes a fifth switch. The third isolation resistor and the fifth switch are coupled in series between two ports with a same phase in the first dividing port and the second dividing port, and the other two ports with a same phase in the first dividing port and the second dividing port are both coupled to the ground end. The other two ports with the same phase in the first dividing port and the second dividing port are both coupled to the ground end, and the two dividing differential terminals in the power divider/combiner are equivalent to single-ended structures. When the power divider/combiner is used as a power divider, the power divider may have a function of converting a differential signal into a single-ended signal. When the power divider/combiner is used as a power combiner, the power combiner may have a function of converting a single-ended signal into a differential signal.

In a possible implementation, the communication device further includes a circuit board, and the power division/combination network is disposed on the circuit board. This is an implementation.

In a possible implementation, the signal dividing port of the power division/combination network receives a signal, and powers of the plurality of second radio frequency circuits are combined into the first radio frequency circuit through the power division/combination network. The power division/combination network may be applied to a receive channel.

In a possible implementation, the signal combining port of the power division/combination network receives a signal, and a power of the first radio frequency circuit is divided into the plurality of second radio frequency circuits through the power division/combination network. The power division/combination network may be applied to a transmit channel.

In a possible implementation, the communication device further includes an antenna, and the antenna is coupled to the second radio frequency circuit. This is an application scenario.

In a possible implementation, the power division/combination network includes one power divider/-combiner, a common port of the power divider/combiner is used as the signal combining port, and a first dividing port and a second dividing port are used as the signal dividing ports. This is an application mode.

In a possible implementation, the power division/combination network includes a plurality of power dividers/combiners, at least some of the plurality of power dividers/combiners are connected in series, and a common port of a lower-level power divider/combiner is coupled to a first dividing port or a second dividing port of an upper-level power divider/combiner; a common port of a first-level power divider/combiner is used as the signal combining port, and first dividing ports and second dividing ports that are of the at least some power dividers/combiners and that are not coupled to the common port are used as the signal dividing ports. This is an application mode.

According to a second aspect, an embodiment of this application provides an operating method of a communication device according to claim 15.

Beneficial effect of the operating method of the communication device according to the second aspect of this embodiment of this application is the same as beneficial effect of the communication device. Details are not described herein again.

In a possible implementation, the mode tuning circuit is further coupled to the second signal transmission network; and the operating mode of the power divider/combiner further includes a third mode, where the third mode is that the first signal transmission network is connected. The operating method of the communication device includes: alternatively, at a same moment, the mode tuning circuit controls the first signal transmission network to be connected, and controls the second signal transmission network to be disconnected, so that the power divider/combiner enters the third mode.

According to a third aspect, an embodiment of this application provides a power divider/combiner. The power divider/combiner includes a common port, a first dividing port, a second dividing port, a first signal transmission network, a second signal transmission network, and a mode tuning circuit. Two ends of the first signal transmission network are coupled to the common port and the first dividing port respectively, two ends of the second signal transmission network are coupled to the common port and the second dividing port respectively, and the mode tuning circuit is coupled to the first signal transmission network and is configured to provide an operating mode tuning capability of the power divider/combiner. An operating mode of the power divider/combiner includes a first mode and a second mode, the first mode is that both the first signal transmission network and the second signal transmission network are connected, and the second mode is that only the second signal transmission network is connected.

According to the power divider/combiner provided in this embodiment of this application, the first signal transmission network is disposed on a first branch, and the second signal transmission network is disposed on a second branch, so that the power divider/combiner can be used as a power divider to well implement a power dividing function, and used as a power combiner to well implement a power combining function. In view of this, the power divider/combiner includes the mode tuning circuit. The mode tuning circuit controls whether the first signal transmission network is connected, to achieve effect of tuning the power divider/combiner to enter the first mode (a dual-connected mode in which both the first signal transmission network and the second signal transmission network are connected) or enter the second mode (a direct-connected mode in which only the second signal transmission network is connected). In this way, the power divider/combiner may be configured to be in the dual-connected mode or the direct-connected mode based on an actual application scenario. If the first signal transmission network and the second signal transmission network do not need to be both connected, the power divider/combiner may be tuned to the direct-connected mode. In the direct-connected mode, power waste on an unused branch can be avoided, and an insertion loss of the power divider/combiner can be reduced.

In a possible implementation, the mode tuning circuit is further coupled to the second signal transmission network; and the operating mode of the power divider/combiner further includes a third mode, where the third mode is that only the first signal transmission network is connected. The mode tuning circuit may further control whether the second signal transmission network is connected, to achieve effect of tuning whether the power divider/combiner enters the third mode (a direct-connected mode in which only the first signal transmission network is connected), so as to increase a mode type of the power divider/combiner.

In a possible implementation, the power divider/combiner further includes an isolation circuit, the isolation circuit is coupled between the first signal transmission network and the second signal transmission network, and the mode tuning circuit is further coupled to the isolation circuit. The isolation circuit is disposed, and the isolation circuit performs an isolation function, so that isolation between the first dividing port and the second dividing port can be increased, and signal leakage can be reduced.

In a possible implementation, the mode tuning circuit includes a first switch, and the first switch is coupled to the first signal transmission network and is configured to control whether the first signal transmission network is connected. This is an implementation with a simple structure.

In a possible implementation, the mode tuning circuit further includes a second switch, and the second switch is coupled to the second signal transmission network and is configured to control whether the second signal transmission network is connected. This is an implementation with a simple structure.

In a possible implementation, the common port includes a positive common differential terminal and a negative common differential terminal, the first dividing port includes a first positive dividing differential terminal and a first negative dividing differential terminal, and the second dividing port includes a second positive dividing differential terminal and a second negative dividing differential terminal. The first signal transmission network includes a first inductor and a second inductor, and the second signal transmission network includes a third inductor and a fourth inductor. A first end of the first inductor and a first end of the third inductor are correspondingly coupled to the positive common differential terminal and the negative common differential terminal, and a second end of the first inductor is coupled to a second end of the third inductor. Two ends of the second inductor are correspondingly coupled to the first positive dividing differential terminal and the first negative dividing differential terminal, and two ends of the fourth inductor are correspondingly coupled to the second positive dividing differential terminal and the second negative dividing differential terminal. The first signal transmission network and the second signal transmission network that are based on a transformer network transmit differential signals, have high immunity to external electromagnetic interference, and can improve radio frequency signal transmission quality. In addition, the first signal transmission network and the second signal transmission network that are based on the transformer network have more advantages in bandwidth, and can meet a high bandwidth requirement.

In a possible implementation, the first signal transmission network further includes a first capacitor, a first end of the first capacitor is coupled to the first end of the first inductor, and a second end of the first capacitor is coupled to a ground end. The second signal transmission network further includes a second capacitor, a first end of the second capacitor is coupled to a first end of a third inductor, and a second end of the second capacitor is coupled to the ground end. The first capacitor and the second capacitor are used as tuning capacitors. The first capacitor and the first inductor resonate together, and the second capacitor and the third inductor resonate together, so that a transformer operates in a required frequency band, and an operating frequency of the transformer can be tuned through tuning.

In a possible implementation, the power divider/combiner further includes a third capacitor, and two ends of the third capacitor are coupled to the first end of the first inductor and the first end of the third inductor respectively. The first inductor and the third inductor on the two transformer networks on the first branch and the second branch share a same tuning capacitor (the third capacitor), so that a structure of the power divider/combiner can be simplified.

In a possible implementation, the first signal transmission network further includes a fourth capacitor, and the second signal transmission network further includes a fifth capacitor. The fourth capacitor is connected in parallel to the second inductor, and the fifth capacitor is connected in parallel to the fourth inductor. The fourth capacitor and the fifth capacitor are used as tuning capacitors. The fourth capacitor and the second inductor resonate together, and the fifth capacitor and the fourth inductor resonate together, so that the transformer operates in the required frequency band, and the operating frequency of the transformer can be tuned through tuning.

In a possible implementation, the common port includes a positive common differential terminal and a negative common differential terminal, the first dividing port includes a first positive dividing differential terminal and a first negative dividing differential terminal, and the second dividing port includes a second positive dividing differential terminal and a second negative dividing differential terminal. The first signal transmission network includes a fifth inductor, a sixth inductor, a sixth capacitor, and a seventh capacitor; and the second signal transmission network includes a seventh inductor, an eighth inductor, an eighth capacitor, and a ninth capacitor. A first end of the fifth inductor and a first end of the seventh inductor are coupled to the positive common differential terminal, a second end of the fifth inductor is coupled to the first positive dividing differential terminal, and a second end of the seventh inductor is coupled to the second positive dividing differential terminal. A first end of the sixth inductor and a first end of the eighth inductor are coupled to the negative common differential terminal, a second end of the sixth inductor is coupled to the first negative dividing differential terminal, and a second end of the eighth inductor is coupled to the second negative dividing differential terminal. The sixth capacitor is coupled between the first end of the fifth inductor and the first end of the sixth inductor, and the seventh capacitor is coupled between the second end of the fifth inductor and the second end of the sixth inductor. The eighth capacitor is coupled between the first end of the seventh inductor and the first end of the eighth inductor, and the ninth capacitor is coupled between the second end of the seventh inductor and the second end of the eighth inductor. The first signal transmission network and the second signal transmission network that are of the structure transmit differential signals, have high immunity to external electromagnetic interference, and can improve radio frequency signal transmission quality.

In a possible implementation, two ends of the first switch in the mode tuning circuit are correspondingly coupled to the first positive dividing differential terminal and the first negative dividing differential terminal. This is an implementation with a simple structure.

In a possible implementation, two ends of the second switch in the mode tuning circuit are correspondingly coupled to the second positive dividing differential terminal and the second negative dividing differential terminal. This is an implementation with a simple structure.

In a possible implementation, the isolation circuit includes a first isolation resistor and a second isolation resistor, and the mode tuning circuit further includes a third switch and a fourth switch. The first isolation resistor and the third switch are coupled in series between the first positive dividing differential terminal and the second positive dividing differential terminal. The second isolation resistor and the fourth switch are coupled in series between the first negative dividing differential terminal and the second negative dividing differential terminal. The first isolation resistor and the second isolation resistor are disposed, and both the first isolation resistor and the second isolation resistor perform an isolation function, so that isolation between the two ports of the first dividing differential terminal and the second dividing differential terminal can be increased (or understood as that signal leakage is near zero). The third switch and the fourth switch are configured to match the first switch and the second switch to tune an operating mode of the power divider/combiner in an operating process of the power divider/combiner.

In a possible implementation, the isolation circuit includes a third isolation resistor, and the mode tuning circuit further includes a fifth switch. The third isolation resistor and the fifth switch are coupled in series between two ports with a same phase in the first dividing port and the second dividing port, and the other two ports with a same phase in the first dividing port and the second dividing port are both coupled to the ground end. The other two ports with the same phase in the first dividing port and the second dividing port are both coupled to the ground end, and the two dividing differential terminals in the power divider/combiner are equivalent to single-ended structures. When the power divider/combiner is used as the power divider, the power divider may have a function of converting a differential signal into a single-ended signal. When the power divider/combiner is used as the power combiner, the power combiner may have a function of converting a single-ended signal into a differential signal.

## BRIEF DESCRIPTION OF DRAWINGS

FIG. 1A is a diagram of a framework of a communication device according to an embodiment of this application;
FIG. 1B is a diagram of a framework of a power division/combination network and a radio frequency circuit according to an embodiment of this application;
FIG. 2A to FIG. 2D are diagrams of structures of a power divider/combiner according to an embodiment of this application;
FIG. 3A to FIG. 3C are diagrams of frameworks of a power divider/combiner according to an embodiment of this application;
FIG. 4 is a diagram of a framework of another power divider/combiner according to an embodiment of this application;
FIG. 5A to FIG. 5C are diagrams of structures of a power divider/combiner according to an embodiment of this application;
FIG. 6A to FIG. 6C are diagrams of structures of another power divider/combiner according to an embodiment of this application;
FIG. 7 is a diagram of a framework of still another power divider/combiner according to an embodiment of this application;
FIG. 8A to FIG. 8C are diagrams of structures of still another power divider/combiner according to an embodiment of this application;
FIG. 9A to FIG. 9C are diagrams of structures of still another power divider/combiner according to an embodiment of this application;
FIG. 10 to FIG. 12 are diagrams of a driving process of a power divider according to an embodiment of this application;
FIG. 13 to FIG. 15 are diagrams of a driving process of a power combiner according to an embodiment of this application;
FIG. 16A to FIG. 16D are diagrams of structures of yet another power divider/combiner according to an embodiment of this application;
FIG. 17A to FIG. 17D are diagrams of structures of yet another power divider/combiner according to an embodiment of this application;
FIG. 18A is a diagram of a structure of a power division/combination network according to an embodiment of this application;
FIG. 18B is a diagram of an equivalent structure of a power division/combination network according to an embodiment of this application; and
FIG. 18C is a diagram of an equivalent structure of another power division/combination network according to an embodiment of this application.

Reference numerals:

100: communication device; 110: processor; 120: external memory interface; 121: internal memory; 130: universal serial bus port; 140: charging management module; 141: power management module; 142: battery; 150: wired communication system; 160: wireless communication system; 170: audio module; 170A: speaker; 170B: receiver; 170C: microphone; 170D: headset jack; 180: sensor module; 190: button; 191: motor; 192: indicator; 193: camera; 194: display; 195: SIM card interface; 300: power divider/combiner; 31: first signal transmission network; 32: second signal transmission network; 33: mode tuning circuit; 34: isolation circuit; O: common port; O1: positive common differential terminal; O2: negative common differential terminal; P: first dividing port; P1: first positive dividing differential terminal; P2: first negative dividing differential terminal; Q: second dividing port; Q1: second positive dividing differential terminal; Q2: second negative dividing differential terminal; A: first branch; B: second branch; R: isolation resistor; L: inductor; C: capacitor; L1: first inductor; L2: second inductor; L3: third inductor; L4: fourth inductor; C1: first capacitor; C2: second capacitor; C3: third capacitor; C4: fourth capacitor; C5: fifth capacitor; S1: first switch; S2: second switch; S3: third switch; S4: fourth switch; S5: fifth switch; R1: first isolation resistor; R2: second isolation resistor; R3: third isolation resistor; X1: first point; X2: second point; and X3: third point.

## DESCRIPTION OF EMBODIMENTS

The following describes technical solutions in embodiments of this application with reference to accompanying drawings in embodiments of this application. It is clear that the described embodiments are merely a part rather than all of embodiments of this application.

In embodiments of this application, terms such as "first" and "second" mentioned below are merely used for ease of description, and shall not be understood as an indication or implication of relative importance or implicit indication of a quantity of indicated technical features. Therefore, a feature limited by "first", "second", or the like may explicitly or implicitly include one or two features. In descriptions of this application, unless otherwise stated, "two" means two or more.

In embodiments of this application, "up", "down", "left", and "right" are not limited to orientations of schematically placed components in relative accompanying drawings. It should be understood that these orientation terms may be relative concepts. The orientation terms are used for relative description and clarification, and may vary correspondingly based on a change in an orientation in which the component is placed in the accompanying drawings.

In embodiments of this application, unless otherwise specified in the context, in the entire specification and claims, a term "include" is interpreted as "open and inclusive", that is, "include, but not limited to". In the descriptions of the specification, terms "one embodiment", "some embodiments", "example embodiments", "for example", "some examples", or the like are intended to indicate that particular features, structures, materials, or characteristics related to embodiments or the examples are included in at least one embodiment or example of the present disclosure. The foregoing example expressions of the terms are not necessarily a same embodiment or example. In addition, the described particular features, structures, materials, or characteristics may be included in any one or two embodiments or examples in any appropriate manner.

In descriptions of some embodiments, expressions of "coupling" and an extended expression thereof may be used. For example, the term "coupling" may be used in describing some embodiments to indicate that two or more components are in direct physical or electrical contact. However, the term "coupling" may alternatively mean that two or more components are not in direct contact with each other, but still collaborate or interact with each other. Embodiments disclosed herein are not necessarily limited to content of this specification.

In embodiments of this application, a term "and/or" is merely an association relationship for describing associated objects, and indicates that three relationships may exist. For example, A and/or B may indicate the following three cases: Only A exists, both A and B exist, and only B exists. In addition, a character "/" in this specification usually indicates an "or" relationship between the associated objects.

In embodiments of this application, an example implementation is described with reference to a sectional view and/or a plane diagram and/or an equivalent circuit diagram that are/is used as idealized example accompanying drawings. In the accompanying drawings, for clarity, thicknesses of layers and regions are increased. Thus, a change in a shape in the accompanying drawings due to, for example, manufacturing techniques and/or tolerances may be envisaged. Therefore, example implementations should not be construed as being limited to a shape of a region shown in this specification, but rather include shape deviations due to, for example, manufacturing. For example, an etching region shown as a rectangle typically has a bending feature. Therefore, the regions shown in the accompanying drawings are essentially examples, and the shapes of the regions are not intended to show actual shapes of regions of a device, and are not intended to limit a scope of the example implementations.

An embodiment of this application provides a communication device. The communication device is, for example, a consumer electronic product, a home electronic product, a vehicle-mounted electronic product, a financial terminal product, or a communication electronic product. The consumer electronic product is, for example, a mobile phone, a tablet computer (pad), a notebook computer, an e-reader, a personal computer (PC), a personal digital assistant (PDA), a desktop display, an intelligent wearable product (for example, a smartwatch or a smart band), a virtual reality (VR) terminal device, an augmented reality (AR) terminal device, or an unmanned aerial vehicle. The home electronic product is, for example, an intelligent lock, a television, a remote control, a refrigerator, and a small rechargeable household appliance (for example, a soy milk maker or a robotic vacuum cleaner). The vehicle-mounted electronic product is, for example, a vehicle-mounted navigator, a vehicle-mounted high-density digital video disc (DVD), or the like. The financial terminal product is, for example, an automated teller machine (ATM), a terminal for self-service business handling, or the like. The communication electronic product is a device for example, a server, a memory, a radar, or a base station.

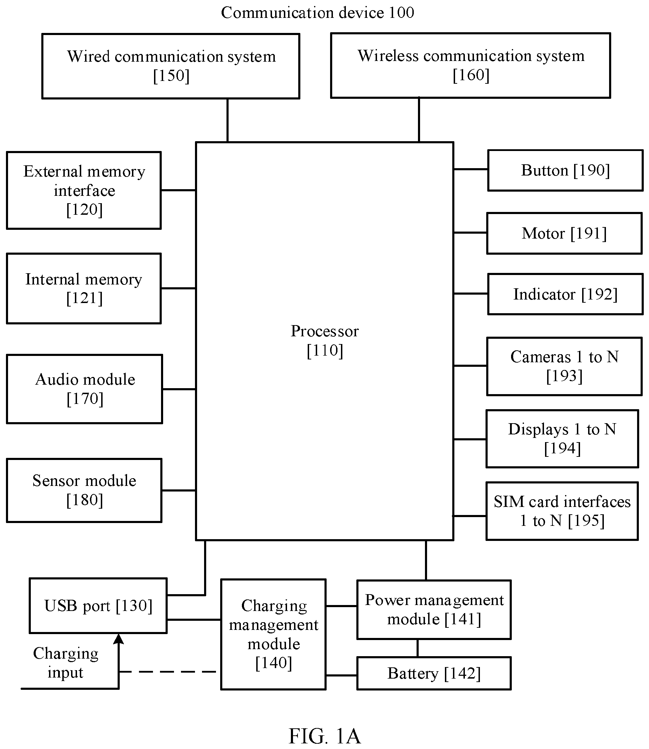

FIG. 1A is a diagram of a structure of an example of a communication device according to an embodiment of this application. An example in which the communication device is a mobile phone is used for description. As shown in FIG. 1A, the communication device 100 may include a processor 110, an external memory interface 120, an internal memory 121, a universal serial bus (USB) port 130, a charging management module 140, a power management module 141, a battery 142, a wired communication system 150, a wireless communication system 160, an audio module 170, a speaker 170A, a receiver 170B, a microphone 170C, a headset jack 170D, a sensor module 180, a button 190, a motor 191, an indicator 192, a camera 193, a display 194, a subscriber identification module (SIM) card interface 195, and the like.

It may be understood that, the structure shown in this embodiment of this application does not constitute a specific limitation on the communication device 100. In some other embodiments of this application, the communication device 100 may include more or fewer components than those shown in the figure, a combination of some components, or splits from some components, or a different component layout. The components shown in the figure may be implemented by hardware, software, or a combination of software and hardware.

The processor 110 may include one or more processing units. For example, the processor 110 may include an application processor (AP), a modem processor, a graphics processing unit (GPU), an image signal processor (ISP), a controller, a video codec, a digital signal processor (DSP), a baseband processor, and/or a neural-network processing unit (NPU). Different processing units may be independent components, or may be integrated into one or more processors. The controller may generate an operation control signal based on an instruction operation code and a time sequence signal, to complete control of instruction fetching and instruction execution.

A memory may be further disposed in the processor 110, and is configured to store instructions and data. In some embodiments, the memory in the processor 110 is a cache. The memory may store instructions or data that has been used or cyclically used by the processor 110. If the processor 110 needs to use the instructions or the data again, the processor may directly invoke the instructions or the data from the memory. This avoids repeated access, reduces waiting time of the processor 110, and improves system efficiency.

In some embodiments, the processor 110 may include one or more interfaces. The interface may include an inter-integrated circuit (I2C) interface, an inter-integrated circuit sound (I2S) interface, a pulse code modulation (PCM) interface, a universal asynchronous receiver/transmitter (UART) interface, a mobile industry processor interface (MIPI), a general-purpose input/output (GPIO) interface, a subscriber identification module (SIM) interface, and/or a universal serial bus (USB) port.

The USB port 130 is a port that conforms to a USB standard specification, and may be specifically a mini USB port, a micro USB port, a USB Type-C port, or the like.

The charging management module 140 is configured to receive a charging input from a charger. The charger may be a wireless charger or a wired charger.

The power management module 141 is configured to connect to the battery 142, the charging management module 140, and the processor 110. The power management module 141 receives an input of the battery 142 and/or the charging management module 140, to supply power to the processor 110, the internal memory 121, the display 194, the camera 193, the wireless communication system 160, and the like. The power management module 141 may be further configured to monitor parameters such as a battery capacity, a battery cycle count, and a battery health status (electricity leakage or impedance).

The communication device 100 may implement a display function by using the GPU, the display 194, the application processor, and the like. The GPU is a microprocessor for image processing, and is connected to the display 194 and the application processor.

The display 194 is configured to display an image, a video, and the like. In some embodiments, the communication device 100 may include one or N displays 194, where N is a positive integer greater than 1.

The communication device 100 may implement a photographing function by using the ISP, the camera 193, the video codec, the GPU, the display 194, the application processor, and the like.

The ISP is configured to process data fed back by the camera 193, the camera 193 is configured to capture a static image or a video, and the video codec is configured to compress or decompress a digital video.

The external memory interface 120 may be configured to connect to an external storage card, for example, a Micro SD card, to extend a storage capability of the communication device 100.

The internal memory 121 may be configured to store computer-executable program code. The executable program code includes instructions.

The communication device 100 may implement an audio function by using the audio module 170, the speaker 170A, the receiver 170B, the microphone 170C, the headset jack 170D, the application processor, and the like.

The audio module 170 is configured to convert digital audio information into an analog audio signal for output, and is also configured to convert an analog audio input into a digital audio signal. The speaker 170A is configured to convert an audio electrical signal into a sound signal. The receiver 170B is configured to convert an audio electrical signal into a sound signal. The microphone 170C is configured to convert a sound signal into an electrical signal. The headset jack 170D is configured to connect to a wired headset.

The sensor module 180 may include an image sensor, a pressure sensor, a magnetic sensor, a distance sensor, and the like. The image sensor may be, for example, a contact image sensor (CIS).

The button 190 includes a power button, a volume button, and the like. The motor 191 may generate a vibration prompt. The indicator 192 may be an indicator lamp, and may be configured to indicate a charging status and a power change, or may be configured to indicate a message, a missed call, a notification, and the like. The SIM card interface 195 is configured to connect to an SIM card.

A communication function of the communication device 100 may be implemented by using the wired communication system 150, the wireless communication system 160, the modem processor, the baseband processor, and the like.

The modem processor may include a modulator and a demodulator. The modulator is configured to modulate a to-be-sent low-frequency baseband signal into a medium-high frequency signal. The demodulator is configured to demodulate a received electromagnetic wave signal into a low-frequency baseband signal. Then, the demodulator transmits the low-frequency baseband signal obtained through demodulation to the baseband processor for processing. The low-frequency baseband signal is processed by the baseband processor and then transmitted to the application processor. The application processor outputs a sound signal by using an audio device (which is not limited to the speaker, the receiver, or the like), or displays an image or a video on the display 194.

The wired communication system 150 may provide a wireless communication solution that includes 2G/3G/4G/5G or the like and that is applied to the communication device 100. The wired communication system 150 may include one or more filters, a switch, a power amplifier, a low noise amplifier (LNA), and the like.

The wireless communication system 160 may provide a wireless communication solution that includes a wireless local area network (WLAN) (for example, a wireless fidelity (Wi-Fi) network), Bluetooth (BT), a global navigation satellite system (GNSS), frequency modulation (FM), a near field communication (NFC) technology, an infrared (IR) technology, or the like and that is applied to the communication device 100.

The communication device 100 further includes a circuit board, for example, a printed circuit board (PCB). Some electronic components in the communication device 100, such as the processor 110 and the internal memory 121, may be disposed on the circuit board.

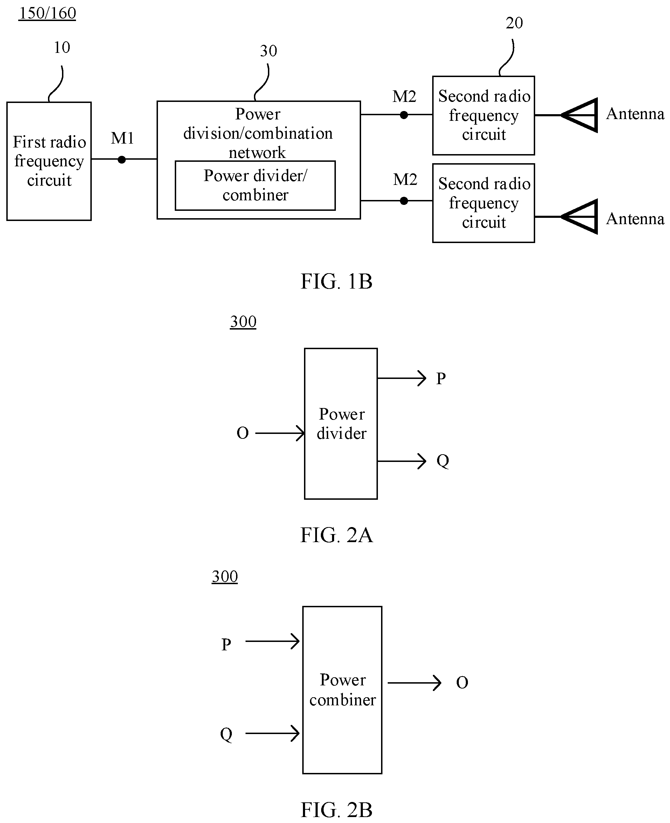

In some embodiments, as shown in FIG. 1B, the wired communication system 150 or the wireless communication system 160 in the communication device 100 includes a first radio frequency circuit 10, a second radio frequency circuit 20, and a power division/combination network 30.

The power division/combination network 30 includes a signal combining port M1 and a plurality of signal dividing ports M2. The signal combining port M1 is configured to transmit a combined signal, and the signal combining port M1 is coupled to the first radio frequency circuit 10. The signal dividing port M2 is configured to transmit a divided signal, and the plurality of signal dividing ports M2 are coupled to a plurality of second radio frequency circuits 20.

In some embodiments, as shown in FIG. 1B, the second radio frequency circuit 20 may be, for example, a radio frequency front-end circuit, and the second radio frequency circuit 20 is further coupled to an antenna.

In a possible implementation, the power division/combination network 30 is applied to a transmit channel, and the power division/combination network 30 is used as a power division network.

In this case, the signal combining port M1 of the power division/combination network 30 receives a signal, and a power of the first radio frequency circuit 10 is divided into the plurality of second radio frequency circuits 20 through the power division/combination network 30.

In another possible implementation, the power division/combination network 30 is applied to a receive channel, and the power division/combination network 30 is used as a power combination network.

In this case, the signal dividing port M2 of the power division/combination network 30 receives a signal, and powers of the plurality of second radio frequency circuits 20 are combined into the first radio frequency circuit 10 through the power division/combination network 30.

The power division/combination network 30 usually includes a plurality of branches, and a quantity of branches included in the power division/combination network 30 is related to a quantity of power dividers/-combiners included in the power division/combination network.

In a possible implementation, the power division/combination network 30 includes one power divider/combiner. In this case, the power division/combination network 30 includes two branches.

In another possible implementation, the power division/combination network 30 includes n (n>1) power dividers/combiners. In this case, the power division/combination network 30 includes more than two (for example, $2^n$) branches.

Certainly, the power division/combination network 30 includes but is not limited to being applied to the wired communication system 150 or the wireless communication system 160. The power division/combination network 30 may be applied to any scenario in which signal division and signal combination are required. For example, the power division/combination network 30 may be applied to a multi-antenna system, a multi-base station system, a multi-branch signal system, a household cable television distribution network, and the like.

In view of this, an embodiment of this application further provides a power divider/combiner. The power divider/combiner includes a common port, a first dividing port, and a second dividing port.

The power divider/combiner provided in this embodiment of this application may be used as a power divider, or may be used as a power combiner. As shown in FIG. 2A, when a common port O is used as a power input port, and a first dividing port P and a second dividing port Q are used as power output ports, a power divider/combiner 300 is used as the power divider, to divide one path of radio frequency signal into two paths of radio frequency signals, so as to divide power into different branches. As shown in FIG. 2B, when the first dividing port P and the second dividing port Q are used as the power input ports, and the common port O is used as the power output port, the power divider/combiner 300 is used as the power combiner, to combine two paths of radio frequency signals into one path of radio frequency signal, so as to combine powers.

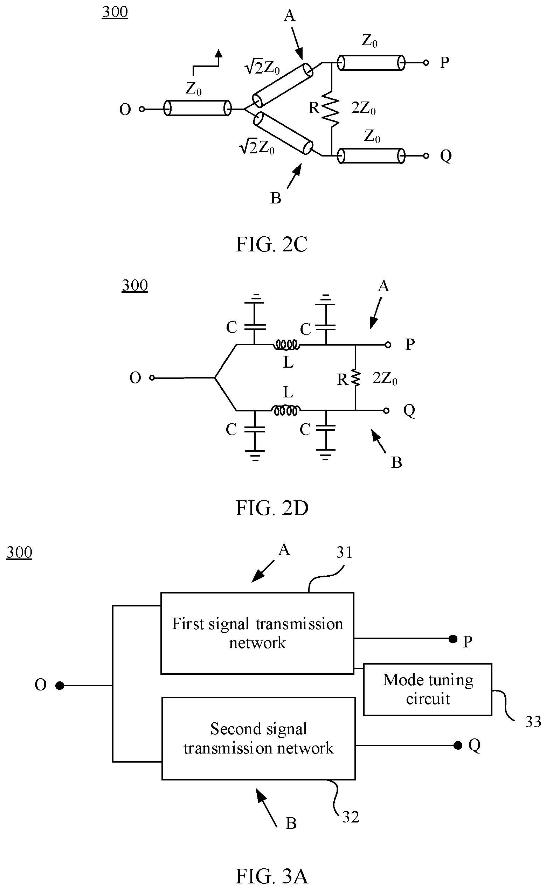

In terms of a structure of the power divider/combiner 300, in some embodiments, as shown in FIG. 2C, a transmission line type single-ended power divider/combiner is provided. The power divider/combiner 300 includes a first branch A and a second branch B, and the first branch A and the second branch B are formed by transmission lines. An isolation resistor R is coupled between the first branch A and the second branch B, and a resistance of the isolation resistor R is twice a characteristic impedance $Z_0$ of the transmission line.

The transmission line type single-ended power divider/combiner has a simple structure and is easy in layout design.

In some other embodiments, as shown in FIG. 2D, a CLC (capacitor-inductor-capacitor) network type single-ended power divider/combiner is provided. The power divider/combiner 300 includes a first branch A and a second branch B, and the first branch A and the second branch B each include an inductor L and two capacitors C. Two ends of the inductor L are coupled to the capacitors C respectively, and the other ends of the capacitors C are coupled to a ground end. An isolation resistor R is coupled between the two branches A and B.

In the CLC network type single-ended power divider/combiner, the inductors L are disposed on the first branch A and the second branch B, so that a winding area of a transmission line can be reduced, and integration of the power divider/combiner can be improved.

However, for any one of the foregoing power dividers/combiners 300, regardless of whether the power divider/combiner 300 is used as the power combiner or as the power divider, in any application scenario, a quantity of branches that are in the power divider/combiner 300 and that are in an operating state is fixed. No matter how many branches are actually in the operating state, each of the branches is in a connected state. However, in actual application, for example, in a phased array system of 5G high-frequency communication, or in some other application scenarios, not all branches need to be in the operating state, to support a changeable application scenario. This causes power waste on a branch that is not used but is in the operating state, resulting in power waste of the power divider/combiner 300, and resulting in a large loss of a communication device.

For example, in some scenarios, only the first branch A is operating, and the second branch B is not operating. In this case, if the second branch B is in the connected state, a power of the second dividing port Q is wasted.

In view of this, an embodiment of this application provides a power divider/combiner whose operating mode is tunable.

As shown in FIG. 3A, a power divider/combiner 300 includes a common port O, a first dividing port P, a second dividing port Q, a first branch A, a second branch B, and a mode tuning circuit 33.

The first branch A includes a first signal transmission network 31, and two ends of the first signal transmission network 31 are coupled to the common port O and the first dividing port P respectively. The second branch B includes a second signal transmission network 32, and two ends of the second signal transmission network 32 are coupled to the common port O and the second dividing port Q respectively.

The mode tuning circuit 33 is coupled to the first signal transmission network 31 and is configured to provide an operating mode tuning capability of the power divider/combiner 300.

An operating mode of the power divider/combiner 300 includes a first mode and a second mode, the first mode is that both the first signal transmission network 31 and the second signal transmission network 32 are connected, and both the first branch A and the second branch B are in a connected state. The second mode is that the second signal transmission network 32 is connected, the first branch A is in a disconnected state, and the second branch B is in the connected state.

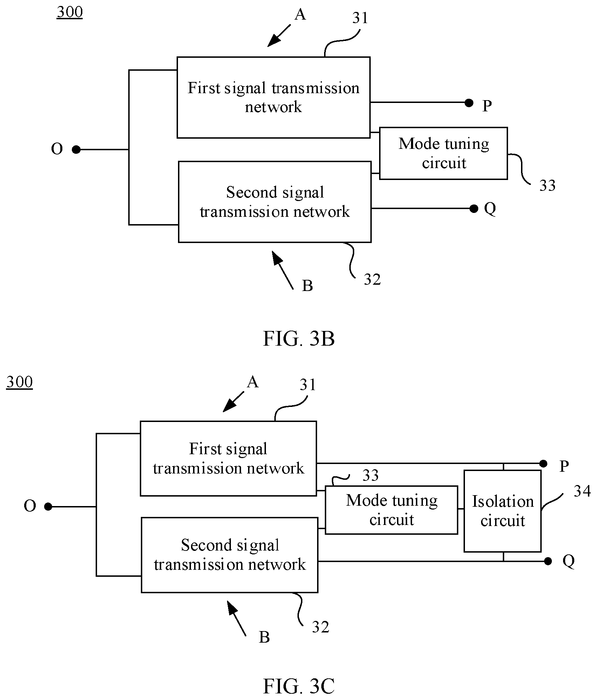

Based on this, as shown in FIG. 3B, the power divider/combiner 300 is further coupled to the second signal transmission network 32, and the mode tuning circuit 33 is configured to provide the operating mode tuning capability of the power divider/combiner 300, so that the operating mode of the power divider/combiner 300 further includes a third mode. The third mode is that the first signal transmission network 31 is connected, the first branch A is in the connected state, and the second branch B is in the disconnected state.

In some embodiments, as shown in FIG. 3C, the power divider/combiner 300 further includes an isolation circuit 34, the isolation circuit 34 is coupled between the first signal transmission network 31 and the second signal transmission network 32, and the mode tuning circuit 33 is further coupled to the isolation circuit 34.

The isolation circuit 34 is disposed, so that isolation between the first dividing port P and the second dividing port Q can be increased, and signal leakage can be reduced.

It can be learned from the foregoing descriptions that the power divider/combiner 300 provided in this embodiment of this application includes the mode tuning circuit 33. The mode tuning circuit 33 controls whether the first signal transmission network 31 is connected, to tune and control whether the first branch A is connected, so as to achieve effect of tuning the power divider/combiner 300 to enter the first mode (a dual-connected mode in which both the first branch A and the second branch B are connected) or enter the second mode (a direct-connected mode in which only the second branch B is connected). If the mode tuning circuit 33 is further coupled to the second signal transmission network 32, the mode tuning circuit 33 may further control whether the second signal transmission network 32 is connected, to tune and control whether the second branch B is connected, so as to achieve effect of tuning whether the power divider/combiner 300 enters the third mode (a direct-connected mode in which only the first branch A is connected). In this way, three different modes may be configured based on an actual application scenario: Both the first branch A and the second branch B are connected (the dual-connected mode), the first branch A is connected (the direct-connected mode), and the second branch B is connected (the direct-connected mode). If the first branch A and the second branch B do not need to be both connected, the power divider/combiner 300 may be tuned to the direct-connected mode. In the direct-connected mode, power waste on an unused branch can be avoided, and an insertion loss of the power divider/combiner 300 can be reduced.

The following uses several detailed examples to describe a structure of the power divider/combiner 300 provided in this embodiment of this application.

Example 1

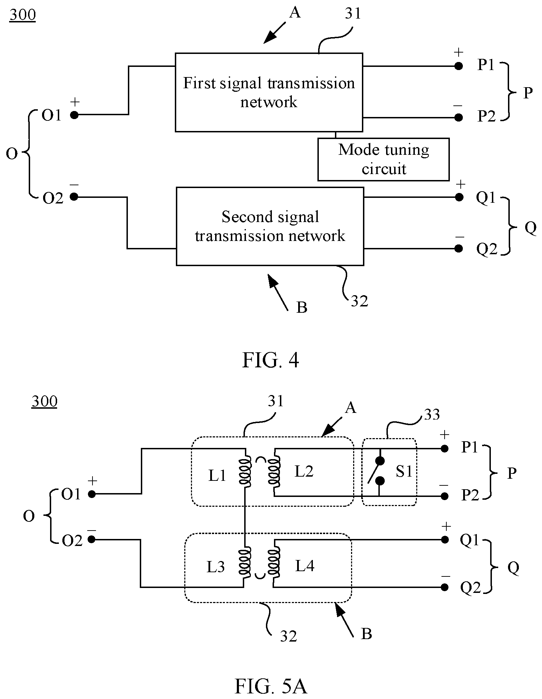

As shown in FIG. 4, a power divider/combiner 300 is provided. The power divider/combiner 300 includes a common port O, a first dividing port P, a second dividing port Q, a first branch A, a second branch B, and a mode tuning circuit 33.

In some embodiments, the common port O includes a pair of common differential terminals. In this embodiment of this application, an example in which the common port O includes a positive common differential terminal O1 and a negative common differential terminal O2 is used for description. The first dividing port P includes a pair of first dividing differential terminals. In this embodiment of this application, an example in which the first dividing port P includes a first positive dividing differential terminal P1 and a first negative dividing differential terminal P2 is used for description. The second dividing port Q includes a pair of second dividing differential terminals. In this embodiment of this application, an example in which the second dividing port Q includes a second positive dividing differential terminal Q1 and a second negative dividing differential terminal Q2 is used for description.

Amplitudes of two signals transmitted on a pair of differential terminals are the same (or understood as that magnitudes are equal), and phases of the two signals are opposite. Signals transmitted through the pair of differential terminals are referred to as differential signals.

Both a first end of the first branch A and a first end of the second branch B are coupled to the common port O, a second end of the first branch A is coupled to the first dividing port P, and a second end of the second branch B is coupled to the second dividing port Q.

In terms of a structure of the branch, in some embodiments, as shown in FIG. 4, the first branch A includes a first signal transmission network 31, and two ends of the first signal transmission network 31 are coupled to the positive common differential terminal O1 in the common port O and a first dividing port P respectively. The second branch B includes a second signal transmission network 32, and two ends of the second signal transmission network 32 are coupled to the negative common differential terminal O2 in the common port O and the second dividing port Q respectively.

In terms of structures of the first signal transmission network 31 and the second signal transmission network 32, in some embodiments, both the first signal transmission network 31 and the second signal transmission network 32 are transformer networks.

For example, as shown in FIG. 5A, the first signal transmission network 31 includes a first inductor L1 and a second inductor L2 that are electromagnetically coupled. The second signal transmission network 32 includes a third inductor L3 and a fourth inductor L4 that are electromagnetically coupled.

A first end of the first inductor L1 and a first end of the third inductor L3 are correspondingly coupled to the positive common differential terminal O1 and the negative common differential terminal O2, and a second end of the first inductor L1 is coupled to a second end of the third inductor L3. Two ends of the second inductor L2 are correspondingly coupled to a pair of first dividing differential terminals (the first positive dividing differential terminal P1 and the first negative dividing differential terminal P2). Two ends of the fourth inductor L4 are correspondingly coupled to a pair of second dividing differential terminals (the second positive dividing differential terminal Q1 and the second negative dividing differential terminal Q2).

For example, the first end of the first inductor L1 is coupled to the positive common differential terminal O1, and the second end of the first inductor L1 is coupled to the second end of the third inductor L3. A first end of the second inductor L2 is coupled to the first positive dividing differential terminal P1, and a second end of the second inductor L2 is coupled to the first negative dividing differential terminal P2. The first end of the third inductor L3 is coupled to the negative common differential terminal O2, and the second end of the third inductor L3 is coupled to the second end of the first inductor L1. A first end of the fourth inductor L4 is coupled to the second positive dividing differential terminal Q1, and a second end of the fourth inductor L4 is coupled to the second negative dividing differential terminal Q2.

The first positive dividing differential terminal P1 and the second positive dividing differential terminal Q1 have a same phase, and the first negative dividing differential terminal P2 and the second negative dividing differential terminal Q2 have a same phase. Therefore, the first end of the second inductor L2 and the first end of the fourth inductor L4 have a same phase, and the second end of the second inductor L2 and the second end of the fourth inductor L4 have a same phase.

It should be noted that, in this embodiment of this application, an example in which the first end of the first inductor L1 is coupled to the positive common differential terminal O1, and the second end of the third inductor L3 is coupled to the negative common differential terminal O2 is merely used for description. The first end of the first inductor L1 may alternatively be coupled to the negative common differential terminal O2, and the second end of the third inductor L3 is coupled to the positive common differential terminal O1. The first end of the first inductor L1 and the first end of the third inductor L3 only need to be correspondingly coupled to the positive common differential terminal O1 and the negative common differential terminal O2.

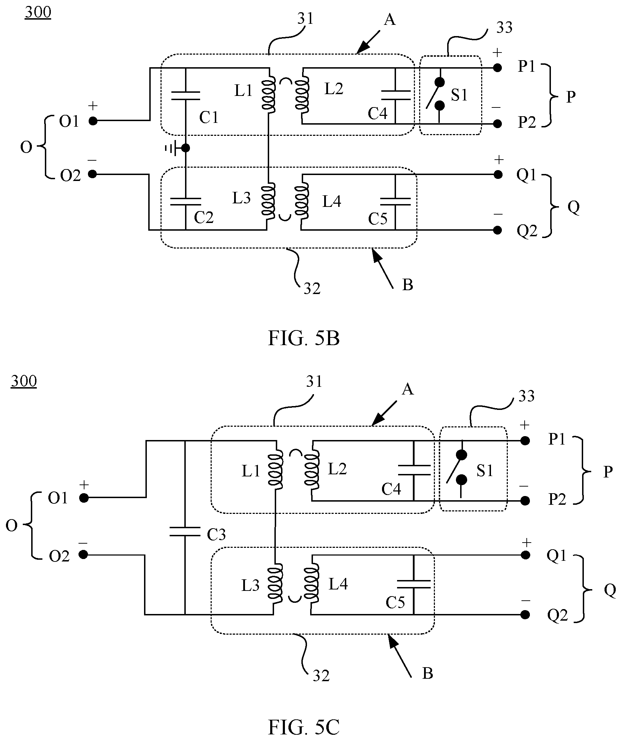

In terms of the structure of the first signal transmission network 31, as shown in FIG. 5B, in some embodiments, the first signal transmission network 31 further includes a first capacitor C1 and/or a fourth capacitor C4, and/or the second signal transmission network 32 further includes a second capacitor C2 and/or a fifth capacitor C5.

For example, the first branch A further includes the first capacitor C1 and the fourth capacitor C4, and the second branch B further includes the second capacitor C2 and the fifth capacitor C5.

In FIG. 5B, an example in which the first branch A includes the first capacitor C1 and the fourth capacitor C4, and the second branch B includes the second capacitor C2 and the fifth capacitor C5 is used for description.

Alternatively, only the first signal transmission network 31 may include the first capacitor C1 and the fourth capacitor C4; only the second signal transmission network 32 may include the second capacitor C2 and the fifth capacitor C5; only the first signal transmission network 31 may include the first capacitor C1; only the first signal transmission network 31 may include the fourth capacitor C4; only the second signal transmission network 32 may include the second capacitor C2; only the second signal transmission network 32 may include the fifth capacitor C5; the first signal transmission network 31 may include the first capacitor C1, and the second signal transmission network 32 may include the second capacitor C2; the first signal transmission network 31 may include the first capacitor C1, and the second signal transmission network 32 may include the fifth capacitor C5; the first signal transmission network 31 may include the fourth capacitor C4, and the second signal transmission network 32 may include the fifth capacitor C5; or the first signal transmission network 31 may include the fourth capacitor C4, and the second signal transmission network 32 may include the second capacitor C2.

If the first signal transmission network 31 includes the first capacitor C1, a first end of the first capacitor C1 is coupled to the first end of the first inductor L1, and a second end of the first capacitor C1 is coupled to a ground end. If the first signal transmission network 31 includes the fourth capacitor C4, the fourth capacitor C4 is connected in parallel to the second inductor L2. In other words, a first end of the fourth capacitor C4 is coupled to the first end of the second inductor L2, and a second end of the fourth capacitor C4 is coupled to the second end of the second inductor L2.

If the second branch B includes the second capacitor C2, a first end of the second capacitor C2 is coupled to the first end of the third inductor L3, and a second end of the second capacitor C2 is coupled to the ground end. In other words, two ends of the second capacitor C2 are correspondingly coupled to the first positive dividing differential terminal O1 and the first negative dividing differential terminal O2. If the second branch B includes the fifth capacitor C5, a first end of the fifth capacitor C5 is coupled to the first end of the fourth inductor L4, and a second end of the fifth capacitor C5 is coupled to the second end of the fourth inductor L4. In other words, two ends of the fifth capacitor C5 are correspondingly coupled to the second positive dividing differential terminal Q1 and the second negative dividing differential terminal Q2.

To be specific, in the power divider/combiner 300 shown in FIG. 5B, the first signal transmission network 31 on the first branch A further includes the first capacitor C1 connected in parallel to the first inductor L1 and the fourth capacitor C4 connected in parallel to the second inductor L2. The first capacitor C1 and the fourth capacitor C4 are used as tuning capacitors. The first capacitor C1 and the first inductor L1 resonate together, and the fourth capacitor C4 and the second inductor L2 resonate together, so that a transformer operates in a required frequency band $(f = \frac{1}{2\pi\sqrt{LC}})$ . C can be tuned via the first capacitor C1 and the fourth capacitor C4, and an operating frequency of the transformer can be tuned. Similarly, the second signal transmission network 32 on the second branch B further includes the second capacitor C2 connected in parallel to the third inductor L3 and the fifth capacitor C5 connected in parallel to the fourth inductor L4. The second capacitor C2 and the fifth capacitor C5 are used as tuning capacitors. The second capacitor C2 and the third inductor L3 resonate together, and the fifth capacitor C5 and the fourth inductor L4 resonate together, so that the transformer operates in the required frequency band $(f = \frac{1}{2\pi\sqrt{LC}})$. C can be tuned via the second capacitor C2 and the fifth capacitor C5, and the operating frequency of the transformer can be tuned.

In terms of the structure of the branch, in some other embodiments, the power divider/combiner 300 further includes a third capacitor, and/or the first branch A further includes the fourth capacitor, and/or the second branch B further includes the fifth capacitor.

For example, as shown in FIG. 5C, the power divider/combiner 300 further includes a third capacitor C3, the first signal transmission network 31 further includes the fourth capacitor C4, and the second signal transmission network 32 further includes the fifth capacitor C5.

If the power divider/combiner 300 includes the third capacitor C3, two ends of the third capacitor C3 are coupled to the first end of the first inductor L1 and the first end of the third inductor L3 respectively.

If the first branch A includes the fourth capacitor C4, the fourth capacitor C4 is connected in parallel to the second inductor L2. The first end of the fourth capacitor C4 is coupled to the first end of the second inductor L2, and the second end of the fourth capacitor C4 is coupled to the second end of the second inductor L2.

If the second branch B includes the fifth capacitor C5, the fifth capacitor C5 is connected in parallel to the fourth inductor L4. The first end of the fifth capacitor C5 is coupled to the first end of the fourth inductor L4, and the second end of the fifth capacitor C5 is coupled to the second end of the fourth inductor L4.

Certainly, alternatively, the power divider/combiner 300 may include only the third capacitor C3; the first signal transmission network 31 may include only the fourth capacitor C4; the second signal transmission network 32 may include only the fifth capacitor C5; the power divider/combiner 300 may include the third capacitor C3, and the first signal transmission network 31 may include the fourth capacitor C4; the power divider/combiner 300 may include the third capacitor C3, and the second signal transmission network 32 may include the fifth capacitor C5; or the first signal transmission network 31 may include the fourth capacitor C4, and the second signal transmission network 32 may include the fifth capacitor C5.

To be specific, compared with that in FIG. 5B, in the power divider/combiner 300 shown in FIG. 5C, the first inductor L1 in the first signal transmission network 31 and the third inductor L3 in the second signal transmission network 32 share a same tuning capacitor (the third capacitor C3), and a structure of the power divider/combiner 300 can be simplified.

It should be emphasized that a coupling coefficient K1 of the first inductor L1 and the second inductor L2 may be equal to or unequal to a coupling coefficient K2 of the third inductor L3 and the fourth inductor L4. When the power divider/combiner 300 is used as a power divider, if K1=K2, a radio frequency signal input by the common port O as an input end is equally divided into the first branch A and the second branch B. If K1≠K2, a radio frequency signal input by the common port O as the input end is unequally divided into the first branch A and the second branch B.

In some embodiments, on the first branch A, an inductance ratio (namely, an impedance ratio) of the first inductor L1 to the second inductor L2 is 1, 2, or 1/2.

In this way, on the first branch A, a magnitude of the radio frequency signal received by the first inductor L1 is equal to or similar to a magnitude of the radio frequency signal obtained by performing coupling by the second inductor L2.

In some embodiments, on the second branch B, an inductance ratio (namely, an impedance ratio) of the third inductor L3 to the fourth inductor L4 is 1, 2, or 1/2.

In this way, on the first branch A, a magnitude of the radio frequency signal received by the third inductor L3 is equal to or similar to a magnitude of the radio frequency signal obtained by performing coupling by the fourth inductor L4.

The structure of the first branch A may be the same as or different from the structure of the second branch B. This is not limited in embodiments of this application.

Still refer to FIG. 4. The mode tuning circuit 33 is coupled to the first signal transmission network 31.

In terms of a structure of the mode tuning circuit 33, in some embodiments, as shown in FIG. 5A, the mode tuning circuit 33 includes a first switch S1, and the first switch S1 is coupled to the first signal transmission network 31 and is configured to control whether the first signal transmission network 31 is connected.

For example, as shown in FIG. 5A to FIG. 5C, the first switch S1 is coupled between the first signal transmission network 31 and the first dividing port P, and two ends of the first switch S1 are correspondingly coupled to the first positive dividing differential terminal P1 and the first negative dividing differential terminal P2.

For example, the first switch S1 is connected in parallel to the second inductor L2, the two ends of the first switch S1 are correspondingly coupled to the two ends of the second inductor L2, and the first switch S1 is coupled between the second inductor L2 and the first dividing port P.

In terms of a structure of the first switch S1, the first switch S1 may include one switch, the first switch S1 may include a plurality of switches connected in series, or the first switch S1 may include a plurality of switches connected in parallel. A specific structure of the first switch S1 is not limited in embodiments of this application.

In some embodiments, the first switch S1 is a diode. For example, the first switch S1 may be controlled to be turned on and turned off through a digital signal.

In some other embodiments, the first switch S1 is a triode. For example, the first switch S1 may be controlled to be turned on and turned off through an analog signal.

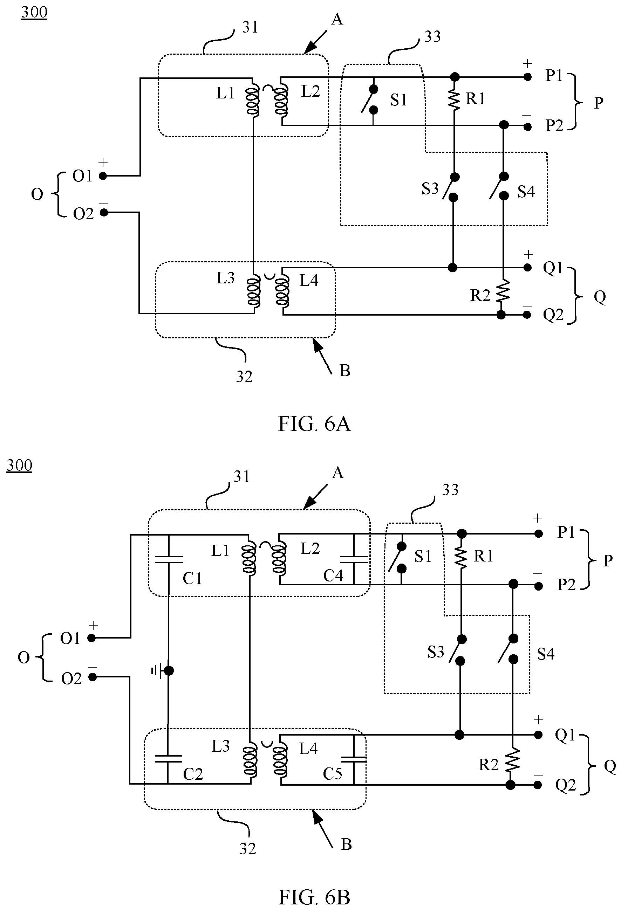

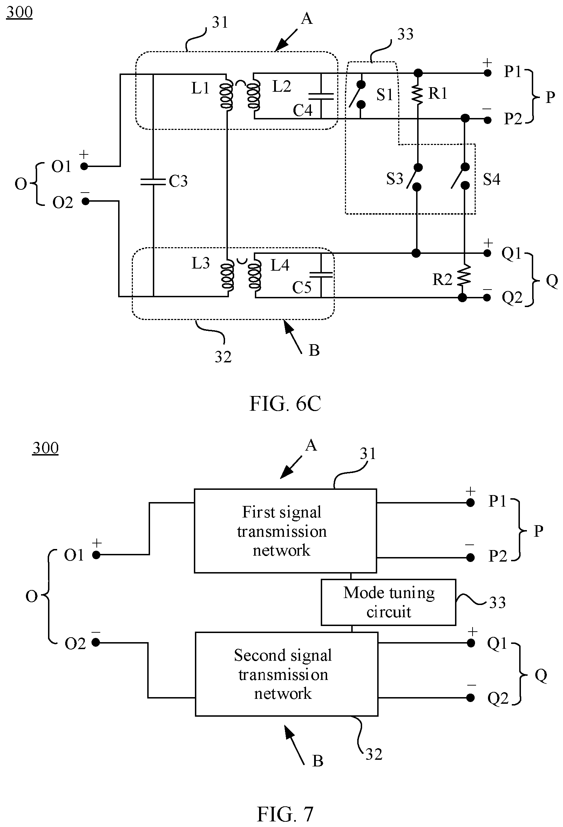

In view of this, as shown in FIG. 6A to FIG. 6C, in some embodiments, an isolation circuit includes a first isolation resistor R1 and a second isolation resistor R2. The mode tuning circuit 33 further includes a third switch S3 and a fourth switch S4.

The first isolation resistor R1 and the third switch S3 are coupled in series between the first positive dividing differential terminal P1 and the second positive dividing differential terminal Q1 (the first end of the second inductor L2 and the first end of the fourth inductor L4). The second isolation resistor R2 and the fourth switch S4 are coupled in series between the first negative dividing differential terminal P2 and the second negative dividing differential terminal Q2 (the second end of the second inductor L2 and the second end of the fourth inductor L4).

Alternatively, it is understood as that the first isolation resistor R1 and the third switch S3 are coupled in series between the first end of the second inductor L2 and the first end of the fourth inductor L4. The second isolation resistor R2 and the fourth switch S4 are coupled in series between the second end of the second inductor L2 and the second end of the fourth inductor L4.

The first isolation resistor R1 and the second isolation resistor R2 each may include one resistor, the first isolation resistor R1 and the second isolation resistor R2 each may include a plurality of resistors connected in series, or the first isolation resistor R1 and the second isolation resistor R2 each may include a plurality of resistors connected in parallel. Certainly, the first isolation resistor R1 and the second isolation resistor R2 may alternatively include another equivalent resistor structure (for example, a source follower transistor). This is not limited in embodiments of this application.

In some embodiments, the first isolation resistor R1 and the second isolation resistor R2 may be leaded resistors, SMD resistors, or the like. In some other embodiments, the first isolation resistor R1 and the second isolation resistor R2 are thin film resistors. The thin film resistor has good heat dissipation efficiency, and can greatly improve operating reliability of the power divider/-combiner 300.

Structures of the third switch S3 and the fourth switch S4 may be the same as the structure of the first switch S1. For details, refer to the foregoing related descriptions of the first switch S1. Details are not described herein again.

The first isolation resistor R1 and the second isolation resistor R2 are disposed, and both the first isolation resistor R1 and the second isolation resistor R2 perform an isolation function. After the first isolation resistor R1 and the second isolation resistor R2 are disposed, through even-odd mode analysis, isolation between the two ports of the first dividing port P and the second dividing port Q can be increased (or understood as that signal leakage is near zero). The third switch S3 connected in series to the first isolation resistor R1 is disposed, so that whether the first branch A and the second branch B are connected can be controlled. Similarly, the fourth switch S4 connected in series to the second isolation resistor R2 is disposed, so that whether the first branch A and the second branch B are connected can be controlled. In this way, an operating mode of the power divider/combiner 300 can be mediated.

In some embodiments, one terminal in the first dividing differential terminal P is coupled to the ground end, and one terminal in the second dividing differential terminal Q is coupled to the ground end.

It may also be understood as that the first positive dividing differential terminal P1 or the first negative dividing differential terminal P2 is coupled to the ground end, and the second positive dividing differential terminal Q1 or the second negative dividing differential terminal Q2 is coupled to the ground end.

For example, the first negative dividing differential terminal P2 in the first dividing differential terminal P is coupled to the ground end, and the second negative dividing differential terminal Q2 in the second dividing differential terminal Q is coupled to the ground end.

Alternatively, for example, the first positive dividing differential terminal P1 in the first dividing differential terminal P is coupled to the ground end, and the second positive dividing differential terminal Q1 in the second dividing differential terminal Q is coupled to the ground end.

Alternatively, for example, the first negative dividing differential terminal P2 in the first dividing differential terminal P is coupled to the ground end, and the second positive dividing differential terminal Q1 in the second dividing differential terminal Q is coupled to the ground end.

Alternatively, for example, the first positive dividing differential terminal P1 in the first dividing differential terminal P is coupled to the ground end, and the second negative dividing differential terminal Q2 in the second dividing differential terminal Q is coupled to the ground end.

In this way, the first dividing differential terminal P and the second dividing differential terminal Q in the power divider/combiner 300 are equivalent to single-ended structures. When the power divider/combiner 300 is used as the power divider, the power divider may have a function of converting a differential signal into a single-ended signal. When the power divider/combiner 300 is used as the power combiner, the power combiner may have a function of converting a single-ended signal into a differential signal.

In view of this, as shown in FIG. 7, the mode tuning circuit 33 is further coupled to the second signal transmission network 32.

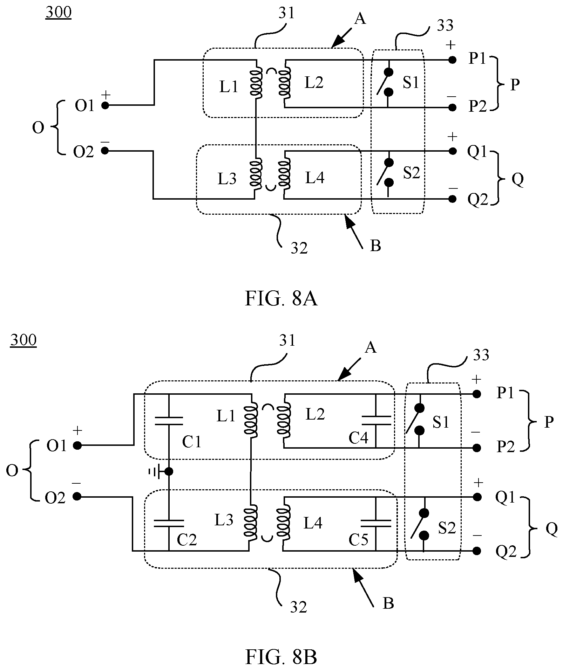

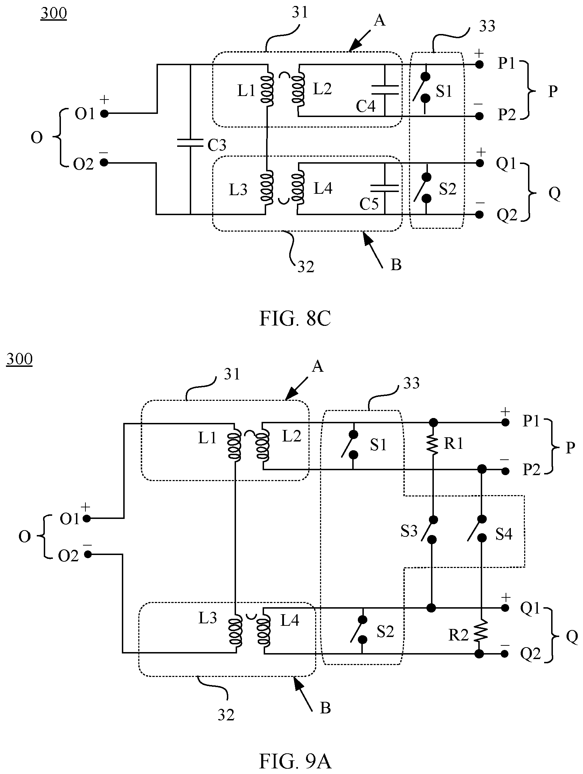

In some embodiments, as shown in FIG. 8A, the mode tuning circuit 33 further includes a second switch S2, and the second switch S2 is coupled to the second signal transmission network 32 and is configured to control whether the second signal transmission network 32 is connected.

For example, as shown in FIG. 8A to FIG. 8C, the second switch S2 is coupled between the second signal transmission network 32 and the second dividing port Q, and two ends of the second switch S2 are correspondingly coupled to the second positive dividing differential terminal Q1 and the second negative dividing differential terminal Q2.

For example, the second switch S2 is connected in parallel to the fourth inductor L4. The two ends of the second switch S2 are correspondingly coupled to the two ends of the fourth inductor L4, and the second switch S2 is coupled between the fourth inductor L4 and the second dividing port Q.

A structure of the second switch S2 may be the same as the structure of the first switch S1. For details, refer to the foregoing related descriptions of the first switch S1.

The mode tuning circuit 33 is further coupled to the second signal transmission network 32, so that the second switch S2 can control whether the second branch B is connected, to tune the operating mode of the power divider/combiner 300.

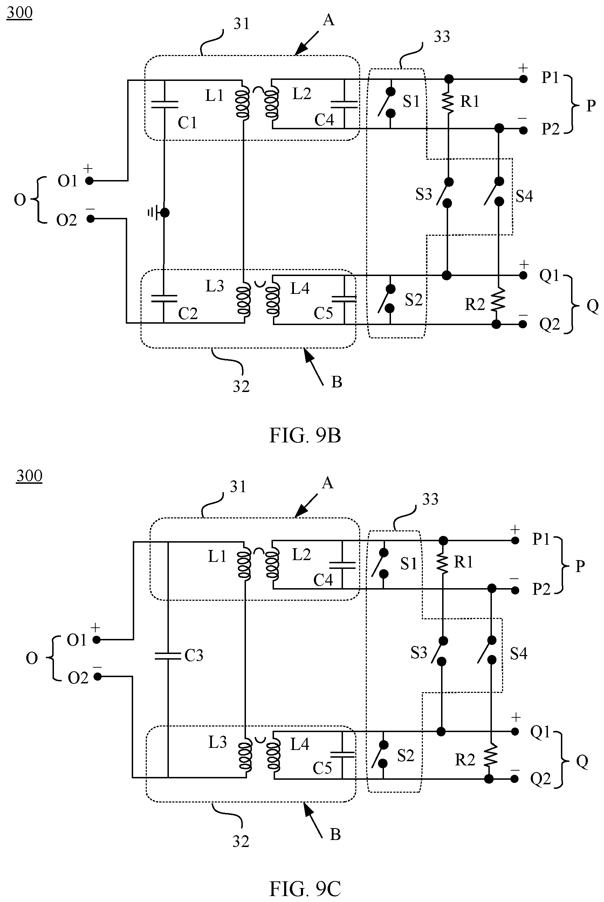

In some embodiments, as shown in FIG. 9A to FIG. 9C, if the power divider/combiner 300 further includes the first isolation resistor R1 and the second isolation resistor R2, the mode tuning circuit 33 may also include the second switch S2.

The power divider/combiner 300 shown in FIG. 9C is used as an example. If the power divider/combiner 300 does not include the mode tuning circuit 33, a division principle corresponding to a case in which the power divider/combiner 300 is used as the power divider is as follows: A radio frequency signal received by the common port O as the input end flows into the first branch A through the positive common differential terminal O1, and flows into the second branch B through the negative common differential terminal O2. The first inductor L1 on the first branch A is used as a primary coil, and the second inductor L2 is used as a secondary coil. The third inductor L3 on the second branch B is used as a primary coil, and the fourth inductor L4 is used as a secondary coil. The second end of the first inductor L1 is coupled to the second end of the third inductor L3, which means that the first inductor L1 is connected in series to the third inductor L3. Based on a voltage division principle, the first inductor L1 and the third inductor L3 perform proportional division on the radio frequency signal, so that a part of the radio frequency signal is electromagnetically coupled to the second inductor L2 of the first branch A, and a part of the radio frequency signal is electromagnetically coupled to the fourth inductor L4 of the second branch B, to divide the radio frequency signal received by the common port O, and output divided radio frequency signals from the first dividing port P and the second dividing port Q respectively.

A combination principle corresponding to a case in which the power divider/combiner 300 is used as the power combiner is as follows: The second inductor L2 on the first branch A is used as a primary coil, and the first inductor L1 is used as a secondary coil. The fourth inductor L4 on the second branch B is used as a primary coil, and the third inductor L3 is used as a secondary coil. On the first branch A, a radio frequency signal received by the first dividing port P as an input end is electromagnetically coupled to the first inductor L1 through the second inductor L2. On the second branch B, a radio frequency signal received by the second dividing port Q as an input end is electromagnetically coupled to the third inductor L3 through the fourth inductor L4. The first inductor L1 is connected in series to the third inductor L3, to combine the radio frequency signals received by the first dividing port P and the second dividing port Q, and output a combined radio frequency signal from the common port O.

Still refer to FIG. 9C. After the power divider/combiner 300 includes the mode tuning circuit 33, a driving process of the power divider/combiner 300 is as follows.

In power division mode:

First mode:

The mode tuning circuit 33 controls the first signal transmission network 31 and the second signal transmission network 32 to be connected, so that the power divider/combiner 300 enters the first mode.

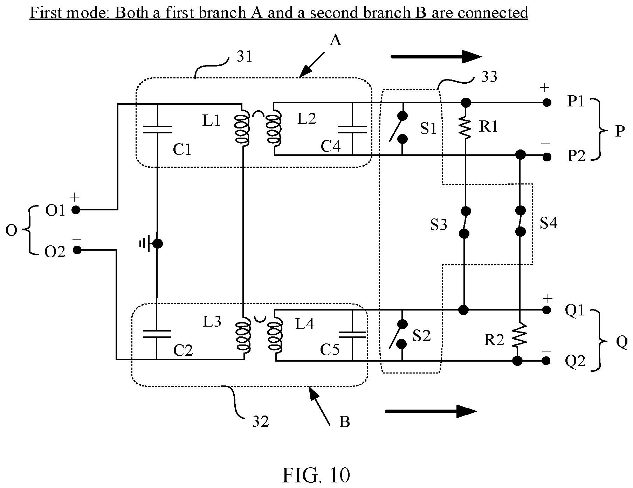

For example, as shown in FIG. 10, the first switch S1 is controlled to be turned off, the second switch S2 is controlled to be turned off, the third switch S3 is controlled to be turned on, and the fourth switch S4 is controlled to be turned on, so that both the first branch A and the second branch B are connected.

After passing through the first branch A and the second branch B, a radio frequency signal of the common port O is divided into the first dividing port P and the second dividing port Q in proportion. For example, a power of the radio frequency signal input by the common port O is p1, and the first branch A and the second branch B equally divide the radio frequency signal. A power p2 obtained by the first dividing port P and a power p3 obtained by the second dividing port Q are approximately: p2=p3=(p1)/2-loss, where loss is losses of the transformer networks on the first branch A and the second branch B at corresponding frequencies.

Second mode:

The mode tuning circuit 33 controls the first signal transmission network 31 to be disconnected, and controls the second signal transmission network 32 to be connected, so that the power divider/combiner 300 enters the second mode.

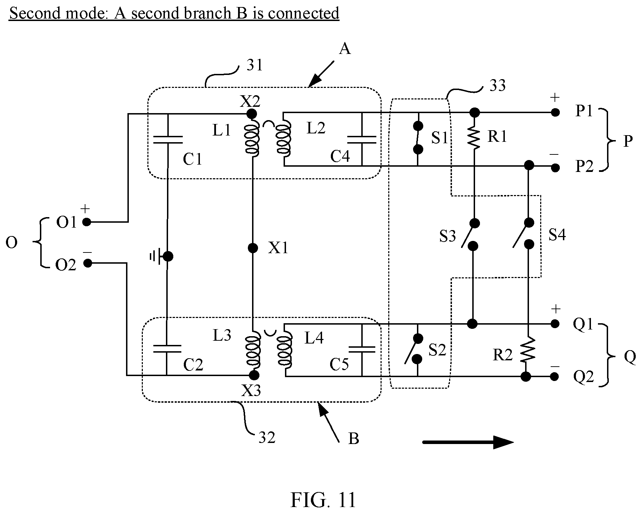

For example, as shown in FIG. 11, the first switch S1 is controlled to be turned on, the second switch S2 is controlled to be turned off, the third switch S3 is controlled to be turned off, and the fourth switch S4 is controlled to be turned off, so that the second branch B is connected.

Because the first switch S1 on the first branch A is turned on, the first dividing port P is short-circuited. Then, the second inductor (a secondary coil of the transformer network) L2 on the first branch A is coupled to a short-circuit load. A resistance from a first point X1 to a second point X2 is low, that is, the first inductor (a primary coil of the transformer network) L1 between the first point X1 and the second point X2 is approximately short-circuited, and the first inductor L1 may be approximately equivalent to a conducting wire. A radio frequency signal transmitted from the positive common differential terminal O1 of the common port O to the second point X2 is transmitted to the first point X1, so that the radio frequency signal of the common port O is all fed to the second branch B without power division. In this case, a power obtained by the second dividing port Q is p3=p1-loss, and a power obtained by the first dividing port P is p2≈0, where loss is a loss of the transformer network on the second branch B at a corresponding frequency.

Third mode:

The mode tuning circuit 33 controls the first signal transmission network 31 to be connected, and controls the second signal transmission network 32 to be disconnected, so that the power divider/combiner 300 enters the third mode.

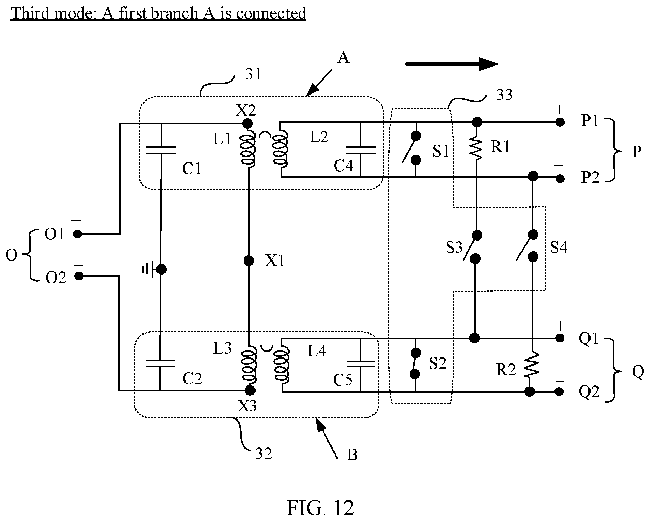

For example, as shown in FIG. 12, the first switch S1 is controlled to be turned off, the second switch S2 is controlled to be turned on, the third switch S3 is controlled to be turned off, and the fourth switch S4 is controlled to be turned off, so that the first branch A is connected.

Because the second switch S2 is turned on, the second dividing port Q is short-circuited. Then, the fourth inductor (a secondary coil of the transformer network) L4 on the second branch B is coupled to a short-circuit load. A resistance from a first point X1 to a third point X3 is low, that is, the third inductor (a primary coil of the transformer network) L3 between the first point X1 and the third point X3 is approximately short-circuited, and the third inductor L3 may be approximately equivalent to a conducting wire. A radio frequency signal transmitted from the negative common differential terminal O2 of the common port O to the third point X3 is transmitted to the first point X1, so that the radio frequency signal of the common port O is all fed to the first branch A, and the radio frequency signal input by the common port O directly reaches the first dividing port P without power division. In this case, a power obtained by the first dividing port P is p2=p1-loss, and a power obtained by the second dividing port Q is p3≈0, where loss is a loss of the transformer network on the first branch A at a corresponding frequency.

If the power divider/combiner 300 is used as the power combiner, a driving process of the power divider/-combiner 300 is as follows.

In power combination mode:

First mode:

The mode tuning circuit 33 controls the first signal transmission network 31 and the second signal transmission network 32 to be connected, so that the power divider/combiner 300 enters the first mode.

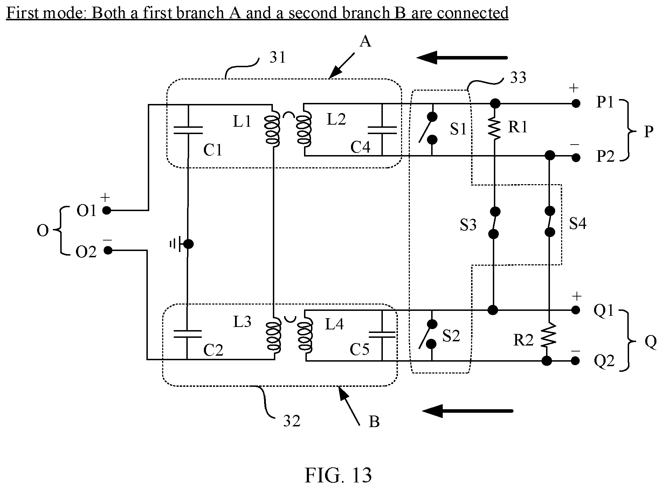

For example, as shown in FIG. 13, the first switch S1 is controlled to be turned off, the second switch S2 is controlled to be turned off, the third switch S3 is controlled to be turned on, and the fourth switch S4 is controlled to be turned on, so that both the first branch A and the second branch B are connected.

A radio frequency signal of the first dividing port P is transmitted to the common port O after passing through the first branch A. A radio frequency signal of the second dividing port Q is transmitted to the common port O after passing through the second branch B. A power p2 of the first dividing port P and a power p3 of the second dividing port Q are combined to the common port O, and a power p1 of the common port O is approximately: p1=p3-loss+p2-loss.

Second mode:

The mode tuning circuit 33 controls the first signal transmission network 31 to be disconnected, and controls the second signal transmission network 32 to be connected, so that the power divider/combiner 300 enters the second mode.

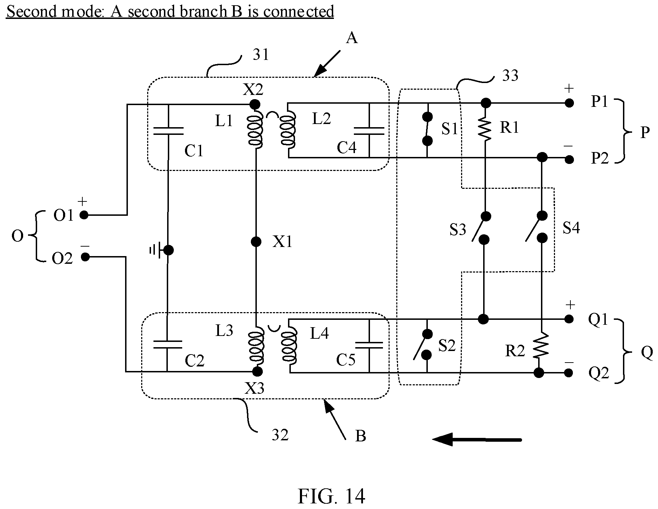

For example, as shown in FIG. 14, the first switch S1 is controlled to be turned on, the second switch S2 is controlled to be turned off, the third switch S3 is controlled to be turned off, and the fourth switch S4 is controlled to be turned off, so that the second branch B is connected.

When a radio frequency signal of the second dividing port Q is transmitted to the common port O through the second branch B, because the first inductor L1 is connected in series to the third inductor L3 of the second branch B, the radio frequency signal flows to a second point X2 through a first point X1. However, because the first switch S1 on the first branch A is turned on, the first dividing port P is short-circuited. Then, the second inductor (a secondary coil of the transformer network) L2 on the first branch A is coupled to a short-circuit load. Therefore, the radio frequency signal in the first inductor L1 is not coupled to the second inductor L2, but is transmitted to the positive common differential terminal O1 of the common port O, so that the radio frequency signal of the second dividing port Q is transmitted to the common port O, and a power p3 of the second dividing port Q directly reaches the common port O. In this case, a power obtained by the common port O is p1=p3-loss.

Third mode:

The mode tuning circuit 33 controls the first signal transmission network 31 to be connected, and controls the second signal transmission network 32 to be disconnected, so that the power divider/combiner 300 enters the third mode.

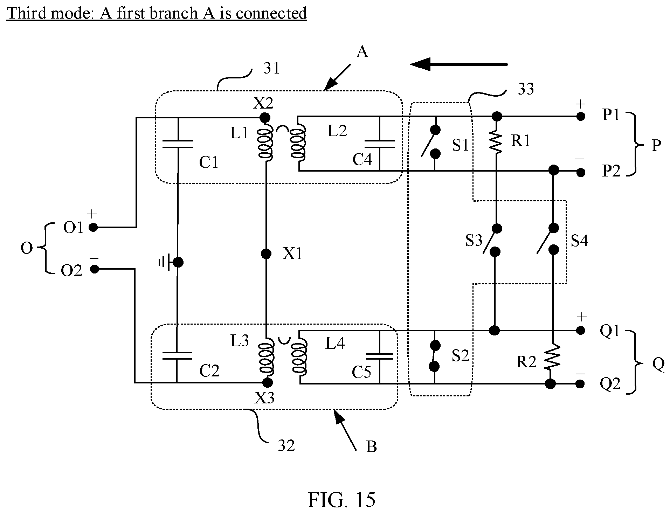

For example, as shown in FIG. 15, the first switch S1 is controlled to be turned off, the second switch S2 is controlled to be turned on, the third switch S3 is controlled to be turned off, and the fourth switch S4 is controlled to be turned off, so that the first branch A is connected.

When a radio frequency signal of the first dividing port P is transmitted to the common port O through the first branch A, because the first inductor L1 is connected in series to the third inductor L3, the radio frequency signal flows to a third point X3 through a first point X1. However, because the second switch S2 is turned on, the second dividing port Q is short-circuited. Then, the fourth inductor (a secondary coil of the transformer network) L4 on the second branch B is coupled to a short-circuit load. Therefore, the radio frequency signal in the third inductor L3 is not coupled to the fourth inductor L4, but is transmitted to the negative common differential terminal O2 of the common port O, so that the radio frequency signal of the first dividing port P is transmitted to the common port O, and a power p2 of the first dividing port P directly reaches the common port O. In this case, a power obtained by the common port O is p1=p2-loss.

If the first positive dividing differential terminal

P1 and the second positive dividing differential terminal Q1 are coupled to the ground end, the third switch S3 may not be driven. If the first negative dividing differential terminal P2 and the second negative dividing differential terminal Q2 are coupled to the ground end, the fourth switch S4 may not be driven.

If the power divider/combiner 300 does not include the first isolation resistor R1, the second isolation resistor R2, the third switch S3, and the fourth switch S4, a process of controlling the third switch S3 and the fourth switch S4 is removed from an operating process of the power divider/combiner 300.

If the mode tuning circuit 33 is not coupled to the second signal transmission network 32, that is, if the mode tuning circuit 33 does not include the second switch S2, a process of controlling the second switch S2 is removed from the operating process of the power divider/combiner 300. In addition, the power divider/combiner 300 does not include the third mode.

It should be emphasized that, in the operating process of the power divider/combiner 300, only one mode in the first mode, the second mode, and the third mode exists at a same moment. Certainly, if a power division/combination network 30 includes a plurality of power dividers/combiners 300, operating modes of the plurality of power dividers/combiners 300 are not limited to be the same, and may be any possibility.

It can be learned from the foregoing descriptions that, according to the power divider/combiner 300 provided in this embodiment of this application, the transformer network including the first inductor L1 and the second inductor L2 is disposed on the first branch A, and the transformer network including the third inductor L3 and the fourth inductor L4 is disposed on the second branch B, so that the power divider/combiner 300 can be used as the power divider to well implement a power dividing function, and used as the power combiner to well implement a power combining function. In addition, the power divider/combiner 300 provided in this embodiment of this application transmits the differential signal, has high immunity to external electromagnetic interference (EMI), and can improve radio frequency signal transmission quality.

In view of this, the power divider/combiner 300 further includes the mode tuning circuit 33, and the first switch S1, the second switch S2, the third switch S3, and the fourth switch S4 in the mode tuning circuit 33 are controlled to be turned on and turned off, so that whether the first branch A and the second branch B are connected can be controlled. In this way, based on an actual application scenario, the power divider/combiner 300 may be configured to enter the first mode (a dual-connected mode), the second mode (a direct-connected mode in which the first branch A is connected), or the third mode (a direct-connected mode in which the second branch B is connected). If the first branch A and the second branch B do not need to be both connected, the power divider/combiner 300 may be tuned to the direct-connected mode. In the direct-connected mode, power waste on an unused branch can be avoided, and an insertion loss of the power divider/combiner 300 can be reduced.

Example 2

A main difference between the example 2 and the example 1 lies in that structures of the first branch A and the second branch B are different.

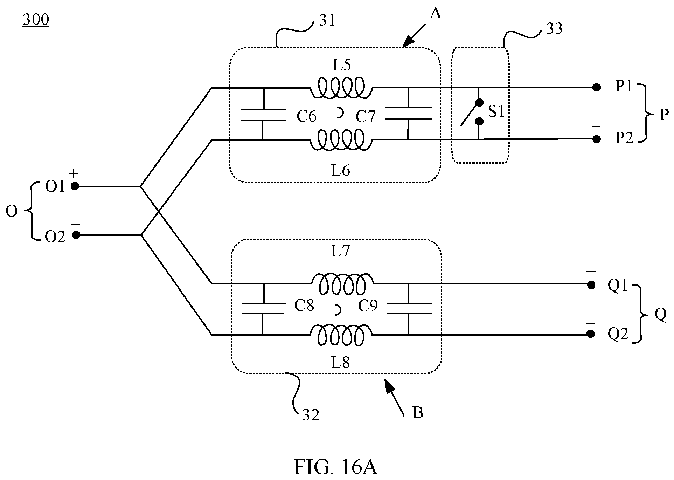

This example provides a power divider/combiner 300. As shown in FIG. 16A, the power divider/combiner 300 includes a common port O, a first dividing port P, a second dividing port Q, a first branch A, a second branch B, and a mode tuning circuit 33.

The common port O, the first dividing port P, the second dividing port Q, and the mode tuning circuit 33 are the same as those in the example 1. For details, refer to the related descriptions of the example 1. Details are not described herein again.

In terms of structures of a first signal transmission network 31 on the first branch A and a second signal transmission network 32 on the second branch B, in some embodiments, as shown in FIG. 16A, the first signal transmission network 31 includes a fifth inductor L5, a sixth inductor L6, a sixth capacitor C6, and a seventh capacitor C7. The second signal transmission network 32 includes a seventh inductor L7, an eighth inductor L8, an eighth capacitor C8, and a ninth capacitor C9.

A first end of the fifth inductor L5 and a first end of the seventh inductor L7 are coupled to a positive common differential terminal O1, a second end of the fifth inductor L5 is coupled to a first positive dividing differential terminal P1, and a second end of the seventh inductor L7 is coupled to a second positive dividing differential terminal Q1.

A first end of the sixth inductor L6 and a first end of the eighth inductor L8 are coupled to a negative common differential terminal O2, a second end of the sixth inductor L6 is coupled to a first negative dividing differential terminal P2, and a second end of the eighth inductor L8 is coupled to a second negative dividing differential terminal Q2.

The sixth capacitor C6 is coupled between the first end of the fifth inductor L5 and the first end of the sixth inductor L6, and the seventh capacitor C7 is coupled between the second end of the fifth inductor L5 and the second end of the sixth inductor L6.

The eighth capacitor C8 is coupled between the first end of the seventh inductor L7 and the first end of the eighth inductor L8, and the ninth capacitor C9 is coupled between the second end of the seventh inductor L7 and the second end of the eighth inductor L8.

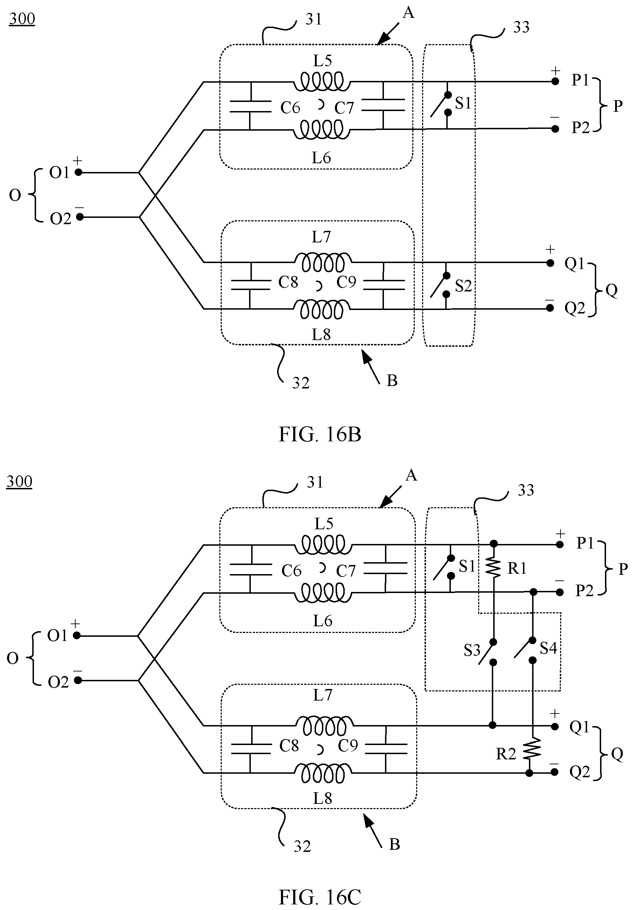

As shown in FIG. 16A, the mode tuning circuit 33 may include only a first switch S1. As shown in FIG. 16B, the mode tuning circuit 33 may alternatively include the first switch S1 and a second switch S2.

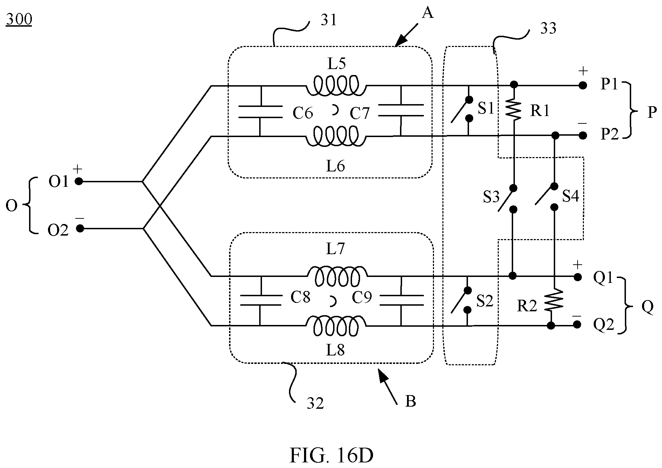

In view of this, as shown in FIG. 16C and FIG. 16D, the power divider/combiner 300 may further include a first isolation resistor R1 and a second isolation resistor R2. The mode tuning circuit 33 may further include a third switch S3 and a fourth switch S4. Structures of the first isolation resistor R1, the second isolation resistor R2, the third switch S3, and the fourth switch S4 may be the same as those in the example 1. For details, refer to the foregoing related descriptions. Details are not described herein again.

Although the structures of the first signal transmission network 31 and the second signal transmission network 32 shown in FIG. 16A may transmit differential signals, compared with the structures of the first signal transmission network 31 and the second signal transmission network 32 that are based on the transformers and that are shown in FIG. 9C, the structures of the first signal transmission network 31 and the second signal transmission network 32 shown in FIG. 9C have more advantages in bandwidth, and can meet a high bandwidth requirement.

Example 3 Main differences between the example 3 and the example 1 and between the example 3 and the example 2 lie in that in this example, an isolation circuit does not include two isolation resistors, but includes only one isolation resistor, and a first dividing port P and a second dividing port Q each have one terminal coupled to a ground end.

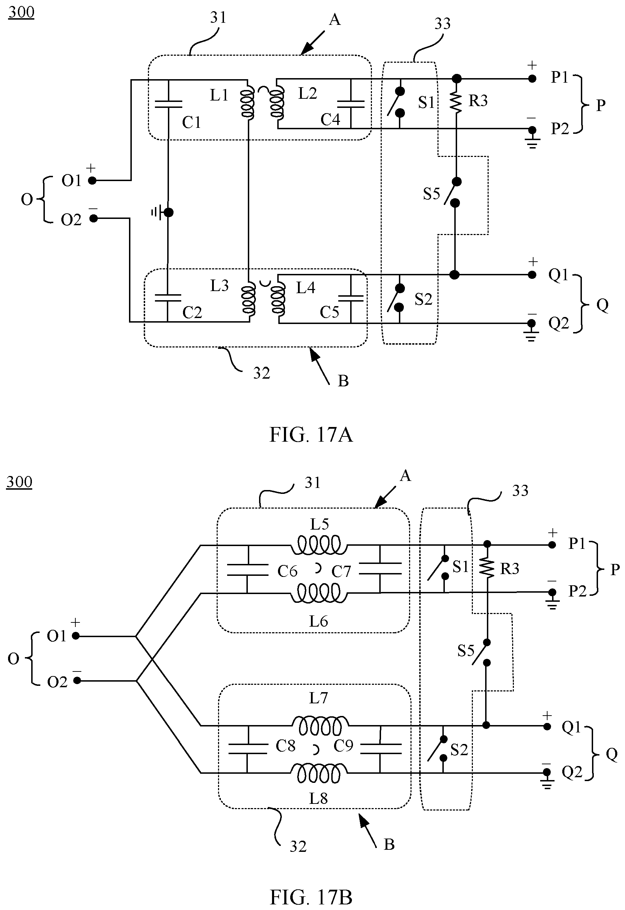

This example provides a power divider/combiner 300. As shown in FIG. 17A, the power divider/combiner 300 includes a common port O, a first dividing port P, a second dividing port Q, a first branch A, a second branch B, a third isolation resistor R3, and a mode tuning circuit 33.

The common port O, the first dividing port P, the second dividing port Q, the first branch A, and the second branch B are the same as those in the example 1 or the example 2. For details, refer to the related descriptions of the example 1 or the example 2.

An isolation circuit includes the third isolation resistor R3, and in addition to including a first switch S1 and/or a second switch S2, the mode tuning circuit 33 further includes a fifth switch S5.

Still refer to FIG. 17A and FIG. 17B. The third isolation resistor R3 and the fifth switch S5 are coupled in series between two ports with a same phase in the first dividing port P and the second dividing port Q, and the other two ports with a same phase in the first dividing port P and the second dividing port Q are both coupled to a ground end.

For example, as shown in FIG. 17A and FIG. 17B, the third isolation resistor R3 and the fifth switch S5 are coupled in series between a first positive dividing differential terminal P1 and a second positive dividing differential terminal Q1, and both a first negative dividing differential terminal P2 and a second negative dividing differential terminal Q2 are coupled to the ground end.

To be specific, the third isolation resistor R3 and the fifth switch S5 are coupled in series between a first end of a second inductor L2 and a first end of a fourth inductor L4, and both a second end of the second inductor L2 and a second end of the fourth inductor L4 are coupled to the ground end (that is, both the first negative dividing differential terminal P2 and the second negative dividing differential terminal Q2 are coupled to the ground end). The first end of the second inductor L2 and the first end of the fourth inductor L4 have a same phase, and the second end of the second inductor L2 and the second end of the fourth inductor L4 have a same phase.

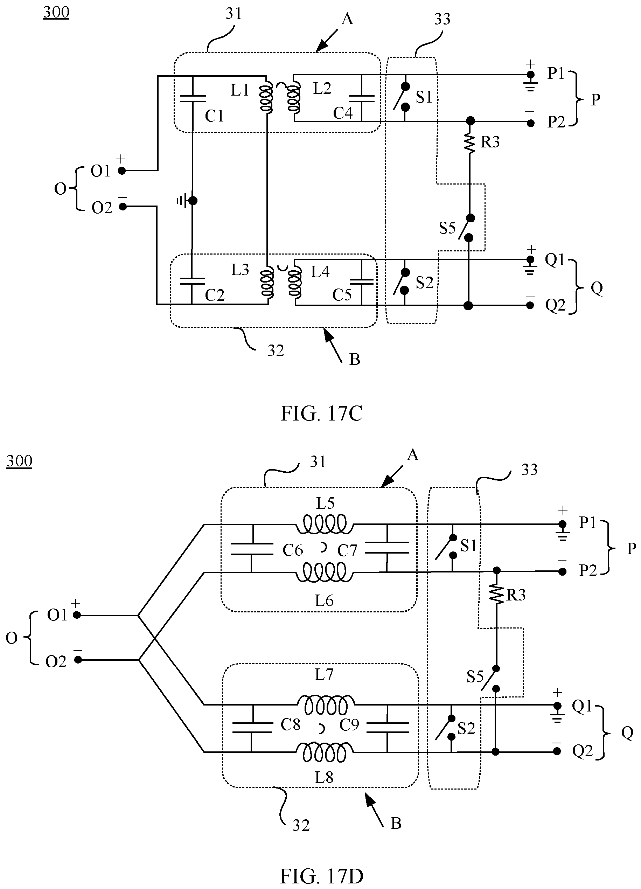

Alternatively, for example, as shown in FIG. 17C and FIG. 17D, the third isolation resistor R3 and the fifth switch S5 are coupled in series between the first negative dividing differential terminal P2 and the second negative dividing differential terminal Q2, and both the first positive dividing differential terminal P1 and the second positive dividing differential terminal Q1 are coupled to the ground end.

To be specific, the third isolation resistor R3 and the fifth switch S5 are coupled in series between the second end of the second inductor L2 and the second end of the fourth inductor L4, and both the first end of the second inductor L2 and the first end of the fourth inductor L4 are coupled to the ground end (that is, both the first positive dividing differential terminal P1 and the second positive dividing differential terminal Q1 are coupled to the ground end). The first end of the second inductor L2 and the first end of the fourth inductor L4 have the same phase, and the second end of the second inductor L2 and the second end of the fourth inductor L4 have the same phase.

A structure of the third isolation resistor R3 may be the same as the structure of the first isolation resistor R1 or the second isolation resistor R2. For details, refer to the foregoing related descriptions of the first isolation resistor R1 and the second isolation resistor R2. Details are not described herein again. A structure of the fifth switch S5 may be the same as the structure of the first switch S1 in the example 1. For details, refer to the foregoing related descriptions of the first switch S1. Details are not described herein again.

In this way, the first dividing differential terminal P and the second dividing differential terminal Q in the power divider/combiner 300 are equivalent to single-ended structures. When the power divider/combiner 300 is used as a power divider, the power divider may have a function of converting a differential signal into a single-ended signal. When the power divider/combiner 300 is used as a power combiner, the power combiner may have a function of converting a single-ended signal into a differential signal.

It should be noted that structures of a first signal transmission network 31 and a second signal transmission network 32 shown in FIG. 17A to FIG. 17D are merely examples, and constitute no limitation. The structures of the first signal transmission network 31 and the second signal transmission network 32 may be the signal transmission networks shown in the example 1 and the example 2.

If the divider/combiner 300 includes the third isolation resistor R3 and the fifth switch S5, if the third isolation resistor R3 and the fifth switch S5 are coupled in series between the first end of the second inductor L2 and the first end of the fourth inductor L4, a driving process of the fifth switch S5 is equivalent to the driving process of the third switch S3. If the third isolation resistor R3 and the fifth switch S5 are coupled in series between the second end of the second inductor L2 and the second end of the fourth inductor L4, a driving process of the fifth switch S5 is equivalent to the driving process of the fourth switch S4.

One terminal in the first dividing differential terminal P and one terminal in the second dividing differential terminal Q are coupled to the ground end, and the first dividing differential terminal P and the second dividing differential terminal Q in the power divider/combiner 300 are equivalent to the single-ended structures. When the power divider/combiner 300 is used as the power divider, the power divider may have the function of converting the differential signal into the single-ended signal. When the power divider/combiner 300 is used as the power combiner, the power combiner may have the function of converting the single-ended signal into the differential signal.

When the power divider/combiner 300 is used in a power division/combination network 30, the power division/combination network 30 may include only one power divider/combiner 300. In this case, the common port O of the power divider/combiner 300 is used as a signal combining port M1 of the power division/combination network 30, and the first dividing port P and the second dividing port Q are used as signal dividing ports M2 of the power division/combination network 30.

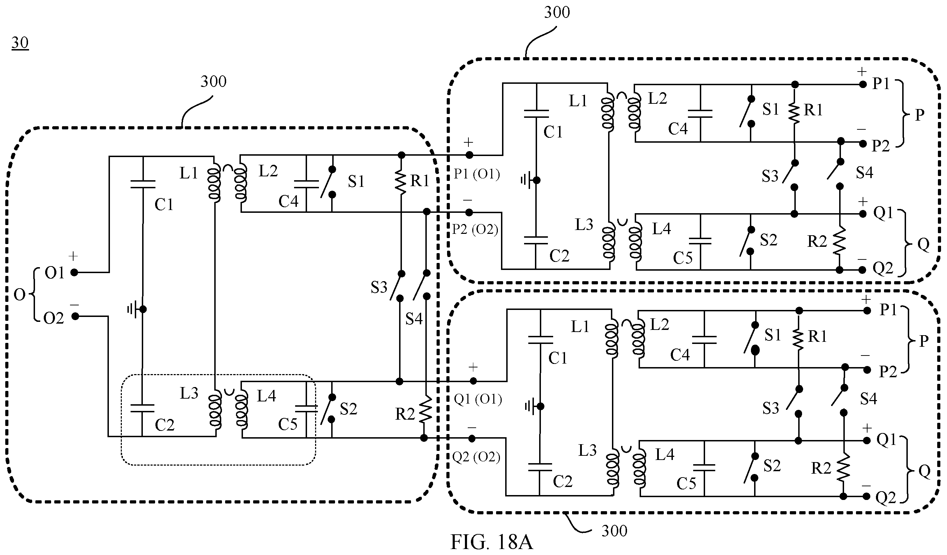

The power division/combination network 30 may include a plurality of power dividers/combiners 300. In this case, as shown in FIG. 18A, a plurality of power dividers/combiners 300 are connected in series level by level. A common port O of a lower-level power divider/combiner 300 is coupled to a first dividing port P or a second dividing port Q of an upper-level power divider/combiner 300, a common port O of a first-level power divider/combiner 300 is used as the signal combining port M1 of the power division/combination network 30, and first dividing ports P and second dividing ports Q that are of the plurality of power dividers/combiners 300 and that are not coupled to the common port O are used as the signal dividing ports M2 of the power division/combination network 30.

It should be noted that, if the power division/combination network 30 includes the plurality of power dividers/combiners 300, structures of the plurality of power dividers/combiners 300 may be the same, structures of the plurality of power dividers/combiners 300 may not be exactly the same, or structures of the plurality of power dividers/combiners 300 are not the same at all. The plurality of power dividers/combiners 300 may be any combination of the foregoing plurality of power dividers/combiners 300.

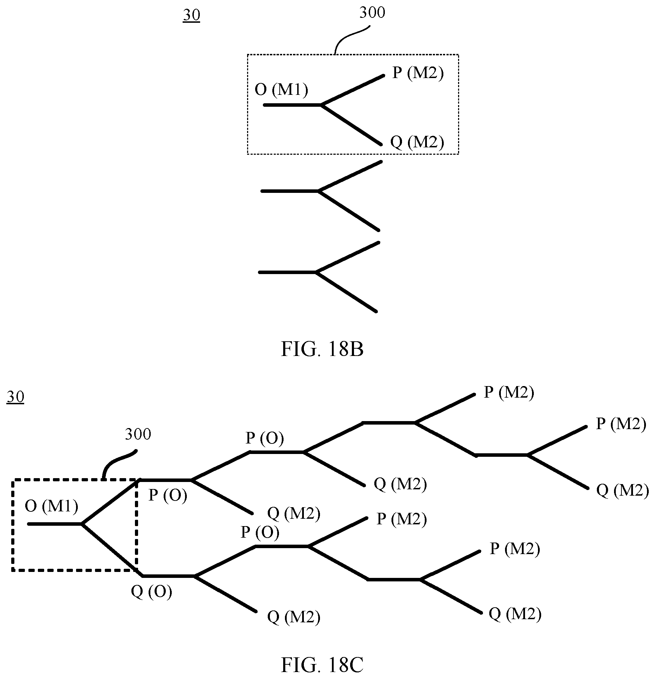

In addition, as shown in FIG. 18B, the plurality of power dividers/combiners 300 included in the power division/combination network 30 may be disposed in parallel.

As shown in FIG. 18C, the plurality of power dividers/combiners 300 may also include a structure disposed in series.

When the power dividers/combiners 300 in the power division/combination network 30 are disposed in series, branches in the power division/combination network 30 spread in a tree branch shape. A quantity of power dividers/combiners 300 included at each level is not limited, and division needs to be properly set. First dividing ports P and second dividing ports Q that are of the plurality of power dividers/combiners 300 and that are not coupled to the common port O are used as the signal dividing ports M2. The signal dividing ports M2 of the power division/combination network 30 are not necessarily located at a same level.

For example, the power division/combination network 30 provided in embodiments of this application may be disposed on a chip in the communication device 100, may be disposed on a PCB in the communication device 100, or certainly may be disposed on a package substrate. This is not limited in embodiments of this application.

The foregoing descriptions are merely specific implementations of this application, but are not intended to limit the protection scope of this application. Any variation or replacement readily figured out by a person skilled in the art within the technical scope disclosed in this application shall fall within the protection scope of this application. Therefore, the protection scope of this application shall be subject to the protection scope of the claims.

## Claims

**1.** A communication device (100), comprising:

a first radio frequency circuit and a plurality of second radio frequency circuits; and

a power division/combination network, comprising a signal combining port and a plurality of signal dividing ports, wherein the signal combining port is coupled to the first radio frequency circuit and is configured to transmit a combined signal, and the plurality of signal dividing ports are coupled to the plurality of second radio frequency circuits and each is configured to transmit a divided signal, wherein

the power division/combination network comprises at least one power divider/combiner (300), and the power divider/combiner (300) comprises a common port (O), a first dividing port (P), a second dividing port (Q), a first signal transmission network (31), a second signal transmission network (32), and a mode tuning circuit (33); and

two ends of the first signal transmission network (31) are coupled to the common port (O) and the first dividing port (P) respectively, two ends of the second signal transmission network (32) are coupled to the common port (O) and the second dividing port (Q) respectively, and the mode tuning circuit (33) is coupled to the first signal transmission network (31) and is configured to provide an operating mode tuning capability of the power divider/combiner (300), wherein

an operating mode of the power divider/combiner (300) comprises a first mode and a second mode, the first mode is that both the first signal transmission network (31) and the second signal transmission network (32) are connected, and the second mode is that only the second signal transmission network (32) is connected;

wherein the mode tuning circuit (33) comprises a first switch (S1), and the first switch (S1) is coupled to the first signal transmission network (31) and is configured to control whether the first signal transmission network (31) is connected;

wherein the common port (O) comprises a positive common differential terminal (O1) and a negative common differential terminal (O2), the first dividing port (P) comprises a first positive dividing differential terminal (P1) and a first negative dividing differential terminal (P2), and the second dividing port (Q) comprises a second positive dividing differential terminal (Q1) and a second negative dividing differential terminal (Q2);

the first signal transmission network (31) comprises a first inductor (L1) and a second inductor (L2), and the second signal transmission network (32) comprises a third inductor (L3) and a fourth inductor (L4); and

a first end of the first inductor (L1) and a first end of the third inductor (L3) are correspondingly coupled to the positive common differential terminal (O1) and the negative common differential terminal (O2), and a second end of the first inductor (L1) is coupled to a second end of the third inductor (L3); two ends of the second inductor (L2) are correspondingly coupled to the first positive dividing differential terminal (P1) and the first negative dividing differential terminal (P2); and two ends of the fourth inductor (L4) are correspondingly coupled to the second positive dividing differential terminal (Q1) and the second negative dividing differential terminal (Q2).

**2.** The communication device (100) according to claim 1, wherein the mode tuning circuit (33) is further coupled to the second signal transmission network (32); and the operating mode of the power divider/-combiner (300) further comprises a third mode, wherein the third mode is that only the first signal transmission network (31) is connected.

**3.** The communication device (100) according to claim 1 or 2, wherein the power divider/combiner (300) further comprises an isolation circuit (34), the isolation circuit (34) is coupled between the first signal transmission network (31) and the second signal transmission network (32), and the mode tuning circuit (33) is further coupled to the isolation circuit (34).

**4.** The communication device (100) according to any one of claims 1 to 3, wherein the mode tuning circuit (33) further comprises a second switch (S2), and the second switch (S2) is coupled to the second signal transmission network (32) and is configured to control whether the second signal transmission network (32) is connected.

**5.** The communication device (100) according to any one of claims 1 to 4, wherein the first signal transmission network (31) further comprises a first capacitor (C1), a first end of the first capacitor (C1) is coupled to the first end of the first inductor (L1), and a second end of the first capacitor (C1) is coupled to a ground end; and

the second signal transmission network (32) further comprises a second capacitor (C2), a first end of the second capacitor (C2) is coupled to a first end of a third inductor (L3), and a second end of the second capacitor (C2) is coupled to the ground end.

**6.** The communication device (100) according to any one of claims 1 to 4, wherein the power divider/combiner (300) further comprises a third capacitor (C3), and two ends of the third capacitor (C3) are coupled to the first end of the first inductor (L1) and the first end of the third inductor (L3) respectively.

**7.** The communication device (100) according to claim 5 or 6, wherein the first signal transmission network (31) further comprises a fourth capacitor (C4), and the second signal transmission network (32) further comprises a fifth capacitor (C5); and

the fourth capacitor (C4) is connected in parallel to the second inductor (L2), and the fifth capacitor (C5) is connected in parallel to the fourth inductor (L4).

**8.** The communication device (100) according to any one of claims 1 to 7, wherein two ends of the first switch (S1) in the mode tuning circuit (33) are correspondingly coupled to the first positive dividing differential terminal (P1) and the first negative dividing differential terminal (P2); and/or

two ends of the second switch (S2) in the mode tuning circuit (33) are correspondingly coupled to the second positive dividing differential terminal (Q1) and the second negative dividing differential terminal (Q2).

**9.** The communication device (100) according to any one of claims 1 to 8, wherein the isolation circuit (34) comprises a first isolation resistor (R1) and a second isolation resistor (R2), and the mode tuning circuit (33) further comprises a third switch (S3) and a fourth switch (S4);

the first isolation resistor (R1) and the third switch (S3) are coupled in series between the first positive dividing differential terminal (P1) and the second positive dividing differential terminal (Q1); and
the second isolation resistor (R2) and the fourth switch (S4) are coupled in series between the first negative dividing differential terminal (P2) and the second negative dividing differential terminal (Q2).

**10.** The communication device (100) according to any one of claims 1 to 8, wherein the isolation circuit (34) comprises a third isolation resistor (R3), and the mode tuning circuit (33) further comprises a fifth switch (S5); and
the third isolation resistor (R3) and the fifth switch (S5) are coupled in series between two ports with a same phase in the first dividing port (P) and the second dividing port (Q), and the other two ports with a same phase in the first dividing port (P) and the second dividing port (Q) are both coupled to the ground end.

**11.** The communication device (100) according to any one of claims 1 to 10, wherein the signal dividing port of the power division/combination network receives a signal, and powers of the plurality of second radio frequency circuits are combined into the first radio frequency circuit through the power division/combination network; or
the signal combining port of the power division/combination network receives a signal, and a power of the first radio frequency circuit is divided into the plurality of second radio frequency circuits through the power division/combination network.

**12.** The communication device (100) according to any one of claims 1 to 11, wherein the communication device (100) further comprises an antenna, and the antenna is coupled to the second radio frequency circuit.

**13.** The communication device (100) according to any one of claims 1 to 12, wherein the power division/combination network comprises one power divider/combiner (300), a common port (O) of the power divider/combiner (300) is used as the signal combining port, and a first dividing port (P) and a second dividing port (Q) are used as the signal dividing ports; or
the power division/combination network comprises a plurality of power dividers/combiners (300), at least some of the plurality of power dividers/combiners (300) are connected in series, and a common port (O) of a lower-level power divider/combiner (300) is coupled to a first dividing port (P) or a second dividing port (Q) of an upper-level power divider/combiner (300); and a common port (O) of a first-level power divider/combiner is used as the signal combining port, and first dividing ports (P) and second dividing ports (Q) that are of the at least some power dividers/combiners (300) and that are not coupled to the common port (O) are used as the signal dividing ports.

**14.** An operating method of a communication device (100), wherein the communication device (100) comprises: a first radio frequency circuit and a plurality of second radio frequency circuits; and a power division/combination network, comprising a signal combining port and a plurality of signal dividing ports, wherein the signal combining port is coupled to the first radio frequency circuit and is configured to transmit a combined signal, and the plurality of signal dividing ports are coupled to the plurality of second radio frequency circuits and are configured to transmit a divided signal, wherein the power division/combination network comprises at least one power divider/combiner (300), and the power divider/combiner (300) comprises a common port (O), a first dividing port (P), a second dividing port (Q), a first signal transmission network (31), a second signal transmission network (32), and a mode tuning circuit (33); and two ends of the first signal transmission network (31) are coupled to the common port (O) and the first dividing port (P) respectively, two ends of the second signal transmission network (32) are coupled to the common port (O) and the second dividing port (Q) respectively, and the mode tuning circuit (33) is coupled to the first signal transmission network (31) and is configured to provide an operating mode tuning capability of the power divider/combiner (300), wherein an operating mode of the power divider/combiner (300) comprises a first mode and a second mode, the first mode is that both the first signal transmission network (31) and the second signal transmission network (32) are connected, and the second mode is that only the second signal transmission network (32) is connected; and

the operating method of the communication device (100) comprises: at a same moment, controlling, by the mode tuning circuit (33), the first signal transmission network (31) and the second signal transmission network (32) to be connected, so that the power divider/combiner (300) enters the first mode; or controlling, by the mode tuning circuit (33), the first signal transmission network (31) to be disconnected, and controlling the second signal transmission network (32) to be connected, so that the power divider/combiner (300) enters the second mode; wherein the mode tuning circuit (33) comprises a first switch, and the first switch is coupled to the first signal transmission network (31) and is configured to control whether the first signal transmission network (31) is connected;
wherein the common port (O) comprises a positive common differential terminal (O1) and a negative common differential terminal (O2), the first dividing port (P) comprises a first positive dividing differential terminal (P1) and a first negative dividing differential terminal (P2), and the second dividing port (Q) comprises a second positive dividing differential terminal (Q1) and a second negative dividing differential terminal (Q2);
the first signal transmission network (31) comprises a first inductor (L1) and a second inductor (L2), and the second signal transmission network (32) comprises a third inductor (L3) and a fourth inductor (L4); and
a first end of the first inductor (L1) and a first end of the third inductor (L3) are correspondingly coupled to the positive common differential terminal (O1) and the negative common differential terminal (O2), and a second end of the first inductor (L1) is coupled to a second end of the third inductor (L3); two ends of the second inductor (L2) are correspondingly coupled to the first positive dividing differential terminal (P1) and the first negative dividing differential terminal (P2); and two ends of the fourth inductor (L4) are correspondingly coupled to the second positive dividing differential terminal (Q1) and the second negative dividing differential terminal (Q2).

**15.** The operating method of the communication device (100) according to claim 14, wherein the mode tuning circuit (33) is further coupled to the second signal transmission network (32); and the operating mode of the power divider/combiner (300) further comprises a third mode, wherein the third mode is that the first signal transmission network (31) is connected; and
the operating method of the communication device (100) comprises:
alternatively, at a same moment, controlling, by the mode tuning circuit (33), the first signal transmission network (31) to be connected, and controlling the second signal transmission network (32) to be disconnected, so that the power divider/combiner (300) enters the third mode.

## Patentansprüche

**1.** Kommunikationsvorrichtung (100), umfassend:

eine erste Hochfrequenzschaltung und eine Mehrzahl von zweiten Hochfrequenzschaltungen; und
ein Leistungsteilungs-/-kombinationsnetzwerk, das einen Signalkombinationsport und eine Mehrzahl von Signalteilungsports umfasst, wobei der Signalkombinationsport mit der ersten Hochfrequenzschaltung gekoppelt und zum Übertragen eines kombinierten Signals ausgelegt ist, und die Mehrzahl von Signalteilungsports mit der Mehrzahl von zweiten Hochfrequenzschaltungen gekoppelt und jeweils zum Übertragen eines geteilten Signals ausgelegt ist, wobei
das Leistungsteilungs-/-kombinationsnetzwerk mindestens einen Leistungsteiler/- kombinierer (300) umfasst und der Leistungsteiler/-kombinierer (300) einen gemeinsamen Port (O), einen ersten Teilungsport (P), einen zweiten Teilungsport (Q), ein erstes Signalübertragungsnetzwerk (31), ein zweites Signalübertragungsnetzwerk (32) und eine Modusabstimmungsschaltung (33) umfasst; und
zwei Enden des ersten Signalübertragungsnetzwerks (31) mit dem gemeinsamen Port (O) bzw. dem ersten Teilungsport (P) gekoppelt sind, zwei Enden des zweiten Signalübertragungsnetzwerks (32) mit dem gemeinsamen Port (O) bzw. dem zweiten Teilungsport (Q) gekoppelt sind und die Modusabstimmungsschaltung (33) mit dem ersten Signalübertragungsnetzwerk (31) gekoppelt und zum Bereitstellen einer Betriebsmodusabstimmungsfähigkeit des Leistungsteilers/-kombinierers (300) ausgelegt ist, wobei
ein Betriebsmodus des Leistungsteilers/-kombiniers (300) einen ersten Modus und einen zweiten Modus umfasst, wobei der erste Modus ist, dass sowohl das erste Signalübertragungsnetzwerk (31) als auch das zweite Signalübertragungsnetzwerk (32) verbunden sind, und der zweite Modus ist, dass nur das zweite Signalübertragungsnetzwerk (32) verbunden ist;
wobei die Modusabstimmungsschaltung (33) einen ersten Schalter (S1) umfasst und der erste Schalter (S1) mit dem ersten Signalübertragungsnetzwerk (31) gekoppelt und so ausgelegt ist, dass er steuert, ob das erste Signalübertragungsnetzwerk (31) verbunden ist;
wobei der gemeinsame Port (O) einen positiven gemeinsamen Differenzanschluss (O1) und einen negativen gemeinsamen Differenzanschluss (O2) umfasst, der erste Teilungsport (P) einen ersten positiven Differenzteilungsanschluss (P1) und einen ersten negativen Differenzteilungsanschluss (P2) umfasst und der zweite Teilungsport (Q) einen zweiten positiven Differenzteilungsanschluss (Q1) und einen zweiten negativen Differenzteilungsanschluss (Q2) umfasst;
das erste Signalübertragungsnetzwerk (31) einen ersten Induktor (L1) und einen zweiten Induktor (L2) umfasst und das zweite Signalübertragungsnetzwerk (32) einen dritten Induktor (L3) und einen vierten Induktor (L4) umfasst; und
ein erstes Ende des ersten Induktors (L1) und ein erstes Ende des dritten Induktors (L3) jeweils mit dem positiven Differenzteilungsanschluss (O1) und dem negativen Differenzteilungsanschluss (O2) gekoppelt sind und ein zweites Ende des ersten Induktors (L1) mit einem zweiten Ende des dritten Induktors (L3) gekoppelt ist; zwei Enden des zweiten Induktors (L2) jeweils mit dem ersten positiven Differenzteilungsanschluss (P1) und dem ersten negativen Differenzteilungsanschluss (P2) gekoppelt sind; und zwei Enden des vierten Induktors (L4) jeweils mit dem zweiten positiven Differenzteilungsanschluss (Q1) und dem zweiten negativen Differenzteilungsanschluss (Q2) gekoppelt sind.

**2.** Kommunikationsvorrichtung (100) nach Anspruch 1, wobei die Modusabstimmungsschaltung (33) ferner mit dem zweiten Signalübertragungsnetzwerk (32) gekoppelt ist und der Betriebsmodus des Leistungsteilers/-kombinierers (300) ferner einen dritten Modus umfasst, wobei der dritte Modus ist, dass nur das erste Signalübertragungsnetzwerk (31) verbunden ist.

**3.** Kommunikationsvorrichtung (100) nach Anspruch 1 oder 2, wobei der Leistungsteiler/-kombinierer (300) ferner eine Isolationsschaltung (34) umfasst, wobei die Isolationsschaltung (34) zwischen das erste Signalübertragungsnetzwerk (31) und das zweite Signalübertragungsnetzwerk (32) gekoppelt ist und die Modusabstimmungsschaltung (33) ferner mit der Isolationsschaltung (34) gekoppelt ist.

**4.** Kommunikationsvorrichtung (100) nach einem der Ansprüche 1 bis 3, wobei die Modusabstimmungsschaltung (33) ferner einen zweiten Schalter (S2) umfasst und der zweite Schalter (S2) mit dem zweiten Signalübertragungsnetzwerk (32) gekoppelt und so ausgelegt ist, dass er steuert, ob das zweite Signalübertragungsnetzwerk (32) verbunden ist.

**5.** Kommunikationsvorrichtung (100) nach einem der Ansprüche 1 bis 4, wobei das erste Signalübertragungsnetzwerk (31) ferner einen ersten Kondensator (C1) umfasst, ein erstes Ende des ersten Kondensators (C1) mit dem ersten Ende des ersten Induktors (L1) gekoppelt ist und ein zweites Ende des ersten Kondensators (C1) mit einem Masseende gekoppelt ist; und
das zweite Signalübertragungsnetzwerk (32) ferner einen zweiten Kondensator (C2) umfasst, ein erstes Ende des zweiten Kondensators (C2) mit einem ersten Ende eines dritten Induktors (L3) gekoppelt ist und ein zweites Ende des zweiten Kondensators (C2) mit dem Masseende gekoppelt ist.

**6.** Kommunikationsvorrichtung (100) nach einem der Ansprüche 1 bis 4, wobei der Leistungsteiler/-kombinierer (300) ferner einen dritten Kondensator (C3) umfasst und zwei Enden des dritten Kondensators (C3) mit dem ersten Ende des ersten Induktors (L1) bzw. dem ersten Ende des dritten Induktors (L3) gekoppelt sind.

**7.** Kommunikationsvorrichtung (100) nach Anspruch 5 oder 6, wobei das erste Signalübertragungsnetzwerk (31) ferner einen vierten Kondensator (C4) umfasst und das zweite Signalübertragungsnetzwerk (32) ferner einen fünften Kondensator (C5) umfasst; und
der vierte Kondensator (C4) zum zweiten Induktor (L2) parallelgeschaltet ist und der fünfte Kondensator (C5) zum vierten Induktor (L4) parallelgeschaltet ist.

**8.** Kommunikationsvorrichtung (100) nach einem der Ansprüche 1 bis 7, wobei zwei Enden des ersten Schalters (S1) in der Modusabstimmungsschaltung (33) jeweils mit dem ersten positiven Differenzteilungsanschluss (P1) und dem ersten negativen Differenzteilungsanschluss (P2) gekoppelt sind; und/oder
zwei Enden des zweiten Schalters (S2) in der Modusabstimmungsschaltung (33) jeweils mit dem zweiten positiven Differenzteilungsanschluss (Q1) und dem zweiten negativen Differenzteilungsanschluss (Q2) gekoppelt sind.

**9.** Kommunikationsvorrichtung (100) nach einem der Ansprüche 1 bis 8, wobei die Isolationsschaltung (34) einen ersten Isolationswiderstand (R1) und einen zweiten Isolationswiderstand (R2) umfasst und die Modusabstimmungsschaltung (33) ferner einen dritten Schalter (S3) und einen vierten Schalter (S4) umfasst;

der erste Isolationswiderstand (R1) und der dritte Schalter (S3) zwischen dem ersten positiven Differenzteilungsanschluss (P1) und dem zweiten positiven Differenzteilungsanschluss (Q1) in Reihe gekoppelt sind; und
der zweite Isolationswiderstand (R2) und der vierte Schalter (S4) zwischen dem ersten negativen Differenzteilungsanschluss (P2) und dem zweiten negativen Differenzteilungsanschluss (Q2) in Reihe gekoppelt sind.

**10.** Kommunikationsvorrichtung (100) nach einem der Ansprüche 1 bis 8, wobei die Isolationsschaltung (34) einen dritten Isolationswiderstand (R3) umfasst und die Modusabstimmungsschaltung (33) ferner einen fünften Schalter (S5) umfasst; und
der dritte Isolationswiderstand (R3) und der fünfte Schalter (S5) zwischen zwei Ports mit einer gleichen Phase in dem ersten Teilungsport (P) und dem zweiten Teilungsport (Q) in Reihe geschaltet sind und die anderen zwei Ports mit einer gleichen Phase in dem ersten Teilungsport (P) und dem zweiten Teilungsport (Q) beide mit dem Masseende gekoppelt sind.

**11.** Kommunikationsvorrichtung (100) nach einem der Ansprüche 1 bis 10, wobei der Signalteilungsport des Leistungsteilungs-/-kombinationsnetzwerks ein Signal empfängt und Leistungen der Mehrzahl von zweiten Hochfrequenzschaltungen über das Leistungsteilungs-/-kombinationsnetzwerk in die erste Hochfrequenzschaltung kombiniert werden; oder
der Signalkombinationsport des Leistungsteilungs-/kombinationsnetzwerks ein Signal empfängt und eine Leistung der ersten Hochfrequenzschaltung über das Leistungsteilungs-/kombinationsnetzwerk in die Mehrzahl von zweiten Hochfrequenzschaltungen geteilt wird.

**12.** Kommunikationsvorrichtung (100) nach einem der Ansprüche 1 bis 11, wobei die Kommunikationsvorrichtung (100) ferner eine Antenne umfasst und die Antenne mit der zweiten Hochfrequenzschaltung gekoppelt ist.

**13.** Kommunikationsvorrichtung (100) nach einem der Ansprüche 1 bis 12, wobei das Leistungsteilungs-/-kombinationsnetzwerk einen Leistungsteiler/-kombinierer (300) umfasst, ein gemeinsamer Port (O) des Leistungsteilers/-kombinierers (300) als der Signalkombinationsport verwendet wird und ein erster Teilungsport (P) und ein zweiter Teilungsport (Q) als die Signalteilungsports verwendet werden; oder
das Leistungsteilungs-/-kombinationsnetzwerk eine Mehrzahl von Leistungsteilern/- kombinierern (300) umfasst, wobei mindestens einige der Mehrzahl von Leistungsteilern/-kombinierern (300) in Reihe geschaltet sind und ein gemeinsamer Port (O) eines Leistungsteilers/-kombinierers (300) einer unteren Ebene mit einem ersten Teilungsport (P) oder einem zweiten Teilungsport (Q) eines Leistungsteilers/-kombinierers (300) einer oberen Ebene gekoppelt ist; und ein gemeinsamer Port (O) eines Leistungsteilers/-kombinierers der ersten Ebene als der Signalkombinationsport verwendet wird und erste Teilungsports (P) und zweite Teilungsports (Q), die von den mindestens einigen Leistungsteilern/-kombinierern (300) sind und die nicht mit dem gemeinsamen Port (O) gekoppelt sind, als die Signalteilungsports verwendet werden.

**14.** Betriebsverfahren für eine Kommunikationsvorrichtung (100), wobei die Kommunikationsvorrichtung (100) Folgendes umfasst:

eine erste Hochfrequenzschaltung und eine Mehrzahl von zweiten Hochfrequenzschaltungen; und ein Leistungsteilungs-/-kombinationsnetzwerk, das einen Signalkombinationsport und eine Mehrzahl von Signalteilungsports umfasst, wobei der Signalkombinationsport mit der ersten Hochfrequenzschaltung gekoppelt und zum Übertragen eines kombinierten Signals ausgelegt ist, und die Mehrzahl von Signalteilungsports mit der Mehrzahl von zweiten Hochfrequenzschaltungen gekoppelt und zum Übertragen eines geteilten Signals ausgelegt ist, wobei das Leistungsteilungs-/-kombinationsnetzwerk mindestens einen Leistungsteiler/-kombinierer (300) umfasst und der Leistungsteiler/-kombinierer (300) einen gemeinsamen Port (O), einen ersten Teilungsport (P), einen zweiten Teilungsport (Q), ein erstes Signalübertragungsnetzwerk (31), ein zweites Signalübertragungsnetzwerk (32) und eine Modusabstimmungsschaltung (33) umfasst; und zwei Enden des ersten Signalübertragungsnetzwerks (31) mit dem gemeinsamen Port (O) bzw. dem ersten Teilungsport (P) gekoppelt sind, zwei Enden des zweiten Signalübertragungsnetzwerks (32) mit dem gemeinsamen Port (O) bzw. dem zweiten Teilungsport (Q) gekoppelt sind, und die Modusabstimmungsschaltung (33) mit dem ersten Signalübertragungsnetzwerk (31) gekoppelt und zum Bereitstellen einer Betriebsmodusabstimmungsfähigkeit des Leistungsteilers/-kombinierers (300) ausgelegt ist, wobei ein Betriebsmodus des Leistungsteilers/-kombiniers (300) einen ersten Modus und einen zweiten Modus umfasst, wobei der erste Modus ist, dass sowohl das erste Signalübertragungsnetzwerk (31) als auch das zweite Signalübertragungsnetzwerk (32) verbunden sind, und der zweite Modus ist, dass nur das zweite Signalübertragungsnetzwerk (32) verbunden ist; und
das Betriebsverfahren der Kommunikationsvorrichtung (100) Folgendes umfasst: gleichzeitiges Steuern des ersten Signalübertragungsnetzwerks (31) und des zweiten Signalübertragungsnetzwerks (32) durch die Modusabstimmungsschaltung (33) derart, dass sie verbunden werden, so dass der Leistungsteiler/-kombinierer (300) in den ersten Modus eintritt; oder Steuern des ersten Signalübertragungsnetzwerks (31) durch die Modusabstimmungsschaltung (33) derart, dass es getrennt wird, und Steuern des zweiten Signalübertragungsnetzwerks (32) derart, dass es verbunden wird, so dass der Leistungsteiler/-kombinierer (300) in den zweiten Modus eintritt;

wobei die Modusabstimmungsschaltung (33) einen ersten Schalter umfasst und der erste Schalter mit dem ersten Signalübertragungsnetzwerk (31) gekoppelt und so ausgelegt ist, dass er steuert, ob das erste Signalübertragungsnetzwerk (31) verbunden ist;

wobei der gemeinsame Port (O) einen positiven gemeinsamen Differenzanschluss (Ol) und einen negativen gemeinsamen Differenzanschluss (O2) umfasst, der erste Teilungsport (P) einen ersten positiven Differenzteilungsanschluss (P1) und einen ersten negativen Differenzteilungsanschluss (P2) umfasst und der zweite Teilungsport (Q) einen zweiten positiven Differenzteilungsanschluss (Q1) und einen zweiten negativen Differenzteilungsanschluss (Q2) umfasst;

das erste Signalübertragungsnetzwerk (31) einen ersten Induktor (L1) und einen zweiten Induktor (L2) umfasst und das zweite Signalübertragungsnetzwerk (32) einen dritten Induktor (L3) und einen vierten Induktor (L4) umfasst; und

ein erstes Ende des ersten Induktors (L1) und ein erstes Ende des dritten Induktors (L3) jeweils mit dem positiven Differenzteilungsanschluss (O1) und dem negativen Differenzteilungsanschluss (O2) gekoppelt sind und ein zweites Ende des ersten Induktors (L1) mit einem zweiten Ende des dritten Induktors (L3) gekoppelt ist;

zwei Enden des zweiten Induktors (L2) jeweils mit dem ersten positiven Differenzteilungsanschluss (P1) und dem ersten negativen Differenzteilungsanschluss (P2) gekoppelt sind; und zwei Enden des vierten Induktors (L4) jeweils mit dem zweiten positiven Differenzteilungsanschluss (Q1) und dem zweiten negativen Differenzteilungsanschluss (Q2) gekoppelt sind.

**15.** Betriebsverfahren für die Kommunikationsvorrichtung (100) nach Anspruch 14, wobei die Modusabstimmungsschaltung (33) ferner mit dem zweiten Signalübertragungsnetzwerk (32) gekoppelt ist und der Betriebsmodus des Leistungsteilers/-kombinierers (300) ferner einen dritten Modus umfasst, wobei der dritte Modus ist, dass das erste Signalübertragungsnetzwerk (31) verbunden ist; und das Betriebsverfahren für die Kommunikationsvorrichtung (100) Folgendes umfasst:
gleichzeitiges Steuern des ersten Signalübertragungsnetzwerks (31) durch die Modusabstimmungsschaltung (33) alternativ derart, dass es verbunden wird, und Steuern des zweiten Signalübertragungsnetzwerks (32) derart, dass es getrennt wird, so dass der Leistungsteiler/-kombinierer (300) in den dritten Modus eintritt.

## Revendications

**1.** Dispositif (100) de communication, comportant :

un premier circuit à radiofréquence et une pluralité de deuxièmes circuits à radiofréquence ; et un réseau de répartition/combinaison de puissance, comportant un port de combinaison de signaux et une pluralité de ports de division de signaux, le port de combinaison de signaux étant couplé au premier circuit à radiofréquence et étant configuré pour émettre un signal combiné, et la pluralité de ports de division de signaux étant couplée à la pluralité de deuxièmes circuits à radiofréquence et chacun étant configuré pour émettre un signal divisé,

le réseau de répartition/combinaison de puissance comportant au moins un répartiteur/combineur (300) de puissance, et le répartiteur/combineur (300) de puissance comportant un port commun (O), un premier port (P) de répartition, un deuxième port (Q) de répartition, un premier réseau (31) de transmission de signaux, un deuxième réseau (32) de transmission de signaux, et un circuit (33) de réglage de mode ; et deux extrémités du premier réseau (31) de transmission de signaux étant couplées respectivement au port commun (O) et au premier port (P) de répartition, deux extrémités du deuxième réseau (32) de transmission de signaux étant couplées respectivement au port commun (O) et au deuxième port (Q) de répartition, et le circuit (33) de réglage de mode étant couplé au premier réseau (31) de transmission de signaux et étant configuré pour fournir une capacité de réglage de mode de fonctionnement du répartiteur/combineur (300) de puissance,

un mode de fonctionnement du répartiteur/combineur (300) de puissance comportant un premier mode et un deuxième mode, le premier mode étant tel que le premier réseau (31) de transmission de signaux et le deuxième réseau (32) de transmission de signaux sont tous deux connectés, et le deuxième mode étant tel que seul le deuxième réseau (32) de transmission de signaux est connecté ;

le circuit (33) de réglage de mode comportant un premier commutateur (S1), et le premier commutateur (S1) étant couplé au premier réseau (31) de transmission de signaux et étant configuré pour commander si le premier réseau (31) de transmission de signaux est connecté ;

le port commun (O) comportant une borne différentielle positive commune (O1) et une borne différentielle négative commune (O2), le premier port (P) de répartition comportant une première borne différentielle positive (P1) de répartition et une première borne différentielle négative (P2) de répartition, et le deuxième port (Q) de répartition comportant une deuxième borne différentielle positive (Q1) de répartition et une deuxième borne différentielle négative (Q2) de répartition ;

le premier réseau (31) de transmission de signaux comportant une première inductance (L1) et une deuxième inductance (L2), et le deuxième réseau (32) de transmission de signaux comportant une troisième inductance (L3) et une quatrième inductance (L4) ; et

une première extrémité de la première inductance (L1) et une première extrémité de la troisième inductance (L3) étant couplées de façon correspondante à la borne différentielle positive commune (O1) et à la borne différentielle négative commune (O2), et une deuxième extrémité de la première inductance (L1) étant couplée à une deuxième extrémité de la troisième inductance (L3) ; deux extrémités de la deuxième inductance (L2) étant couplées de façon correspondante à la première borne différentielle positive (P1) de répartition et à la première borne différentielle négative (P2) de répartition ; et deux extrémités de la quatrième inductance (L4) étant couplées de façon correspondante à la deuxième borne différentielle positive (Q1) de répartition et à la deuxième borne différentielle négative (Q2) de répartition.

**2.** Dispositif (100) de communication selon la revendication 1, le circuit (33) de réglage de mode étant en outre couplé au deuxième réseau (32) de transmission de signaux ; et le mode de fonctionnement du répartiteur/combineur (300) de puissance comportant en outre un troisième mode, le troisième mode étant tel que seul le premier réseau (31) de transmission de signaux est connecté.

**3.** Dispositif (100) de communication selon la revendication 1 ou 2, le répartiteur/combineur (300) de puissance comportant en outre un circuit (34) d'isolement, le circuit (34) d'isolement étant couplé entre le premier réseau (31) de transmission de signaux et le deuxième réseau (32) de transmission de signaux, et le circuit (33) de réglage de mode étant en outre couplé au circuit (34) d'isolement.

**4.** Dispositif (100) de communication selon l'une quelconque des revendications 1 à 3, le circuit (33) de réglage de mode comportant en outre un deuxième commutateur (S2), et le deuxième commutateur (S2) étant couplé au deuxième réseau (32) de transmission de signaux et étant configuré pour commander si le deuxième réseau (32) de transmission de signaux est connecté.

**5.** Dispositif (100) de communication selon l'une quelconque des revendications 1 à 4, le premier réseau (31) de transmission de signaux comportant en outre un premier condensateur (C1), une première extrémité du premier condensateur (C1) étant couplée à la première extrémité de la première inductance (L1), et une deuxième extrémité du premier condensateur (C1) étant couplée à une extrémité de terre ; et le deuxième réseau (32) de transmission de signaux comportant en outre un deuxième condensateur (C2), une première extrémité du deuxième condensateur (C2) étant couplée à une première extrémité d'une troisième inductance (L3), et une deuxième extrémité du deuxième condensateur (C2) étant couplée à l'extrémité de terre.

**6.** Dispositif (100) de communication selon l'une quelconque des revendications 1 à 4, le répartiteur/combineur (300) de puissance comportant en outre un troisième condensateur (C3), et deux extrémités du troisième condensateur (C3) étant couplées respectivement à la première extrémité de la première inductance (L1) et à la première extrémité de la troisième inductance (L3).

**7.** Dispositif (100) de communication selon la revendication 5 ou 6, le premier réseau (31) de transmission de signaux comportant en outre un quatrième condensateur (C4), et le deuxième réseau (32) de transmission de signaux comportant en outre un cinquième condensateur (C5) ; et

le quatrième condensateur (C4) étant connecté en parallèle à la deuxième inductance (L2), et le cinquième condensateur (C5) étant connecté en parallèle à la quatrième inductance (L4).

**8.** Dispositif (100) de communication selon l'une quelconque des revendications 1 à 7, deux extrémités du premier commutateur (S1) dans le circuit (33) de réglage de mode étant couplées de façon correspondante à la première borne différentielle positive (P1) de répartition et à la première borne différentielle négative (P2) de répartition ; et/ou

deux extrémités du deuxième commutateur (S2) dans le circuit (33) de réglage de mode étant couplées de façon correspondante à la deuxième borne différentielle positive (Q1) de répartition et à la deuxième borne différentielle négative (Q2) de répartition.

**9.** Dispositif (100) de communication selon l'une quelconque des revendications 1 à 8, le circuit (34) d'isolement comportant une première résistance (R1) d'isolement et une deuxième résistance (R2) d'isolement, et le circuit (33) de réglage de mode comportant en outre un troisième commutateur (S3) et un quatrième commutateur (S4) :

la première résistance (R1) d'isolement et le troisième commutateur (S3) étant couplés en série entre la première borne différentielle positive (P1) de répartition et la deuxième borne différentielle positive (Q1) de répartition ; et
la deuxième résistance (R2) d'isolement et le quatrième commutateur (S4) étant couplés en série entre la première borne différentielle négative (P2) de répartition et la deuxième borne différentielle négative (Q2) de répartition.

**10.** Dispositif (100) de communication selon l'une quelconque des revendications 1 à 8, le circuit (34) d'isolement comportant une troisième résistance (R3) d'isolement, et le circuit (33) de réglage de mode comportant en outre un cinquième commutateur (S5) ; et
la troisième résistance (R3) d'isolement et le cinquième commutateur (S5) étant couplés en série entre deux ports de même phase dans le premier port (P) de répartition et le deuxième port (Q) de répartition, et les deux autres ports de même phase dans le premier port (P) de répartition et le deuxième port (Q) de répartition étant tous deux couplés à l'extrémité de terre.

**11.** Dispositif (100) de communication selon l'une quelconque des revendications 1 à 10, le port de division de signaux du réseau de répartition/combinaison de puissance recevant un signal, et les puissances de la pluralité de deuxièmes circuits à radiofréquence étant combinées dans le premier circuit à radiofréquence par l'intermédiaire du réseau de répartition/-combinaison de puissance ; ou
le port de combinaison de signaux du réseau de répartition/combinaison de puissance recevant un signal, et une puissance du premier circuit à radiofréquence étant répartie dans la pluralité de deuxièmes circuits à radiofréquence par l'intermédiaire du réseau de répartition/combinaison de puissance.

**12.** Dispositif (100) de communication selon l'une quelconque des revendications 1 à 11, le dispositif (100) de communication comportant en outre une antenne, et l'antenne étant couplée au deuxième circuit à radiofréquence.

**13.** Dispositif (100) de communication selon l'une quelconque des revendications 1 à 12, le réseau de répartition/combinaison de puissance comportant un

répartiteur/combineur (300) de puissance, un port commun (O) du répartiteur/combineur (300) de puissance étant utilisé en tant que port de combinaison de signaux, et un premier port (P) de répartition et un deuxième port (Q) de répartition étant utilisés en tant que ports de division de signaux ; ou
le réseau de répartition/combinaison de puissance comportant une pluralité de répartiteurs/-combineurs (300) de puissance, au moins une partie de la pluralité de répartiteurs/combineurs (300) de puissance étant connectés en série, et un port commun (O) d'un répartiteur/combineur (300) de puissance de niveau inférieur étant couplé à un premier port (P) de répartition ou à un deuxième port (Q) de répartition d'un répartiteur/combineur (300) de puissance de niveau supérieur ; et un port commun (O) d'un répartiteur/combineur de puissance de premier niveau étant utilisé en tant que port de combinaison de signaux, et des premiers ports (P) de répartition et des deuxièmes ports (Q) de répartition qui appartiennent à la partie au moins des répartiteurs/combineurs (300) de puissance et qui ne sont pas couplés au port commun (O) étant utilisés en tant que ports de division de signaux.

**14.** Procédé d'exploitation d'un dispositif (100) de communication, le dispositif (100) de communication comportant : un premier circuit à radiofréquence et une pluralité de deuxièmes circuits à radiofréquence ; et un réseau de répartition/combinaison de puissance, comportant un port de combinaison de signaux et une pluralité de ports de division de signaux, le port de combinaison de signaux étant couplé au premier circuit à radiofréquence et étant configuré pour émettre un signal combiné, et la pluralité de ports de division de signaux étant couplée à la pluralité de deuxièmes circuits à radiofréquence et étant configurée pour émettre un signal divisé, le réseau de répartition/combinaison de puissance comportant au moins un répartiteur/combineur (300) de puissance, et le répartiteur/combineur (300) de puissance comportant un port commun (O), un premier port (P) de répartition, un deuxième port (Q) de répartition, un premier réseau (31) de transmission de signaux, un deuxième réseau (32) de transmission de signaux, et un circuit (33) de réglage de mode ; et deux extrémités du premier réseau (31) de transmission de signaux étant couplées respectivement au port commun (O) et au premier port (P) de répartition, deux extrémités du deuxième réseau (32) de transmission de signaux étant couplées respectivement au port commun (O) et au deuxième port (Q) de répartition, et le circuit (33) de réglage de mode étant couplé au premier réseau (31) de transmission de signaux et étant configuré pour fournir une capacité de réglage de mode de fonctionnement du répartiteur/combineur (300) de puissance, un mode de

fonctionnement du répartiteur/combineur (300) de puissance comportant un premier mode et un deuxième mode, le premier mode étant tel que le premier réseau (31) de transmission de signaux et le deuxième réseau (32) de transmission de signaux sont tous deux connectés, et le deuxième mode étant tel que seul le deuxième réseau (32) de transmission de signaux est connecté ; et

le procédé d'exploitation du dispositif (100) de communication comportant : à un même instant, la commande, par le circuit (33) de réglage de mode, du premier réseau (31) de transmission de signaux et du deuxième réseau (32) de transmission de signaux pour qu'ils soient connectés, de telle sorte que le répartiteur/combineur (300) de puissance entre dans le premier mode ; ou la commande, par le circuit (33) de réglage de mode, du premier réseau (31) de transmission de signaux pour qu'il soit déconnecté, et la commande du deuxième réseau (32) de transmission de signaux pour qu'il soit connecté, de telle sorte que le répartiteur/combineur (300) de puissance entre dans le deuxième mode ;

le circuit (33) de réglage de mode comportant un premier commutateur, et le premier commutateur étant couplé au premier réseau (31) de transmission de signaux et étant configuré pour commander si le premier réseau (31) de transmission de signaux est connecté ;

le port commun (O) comportant une borne différentielle positive commune (O1) et une borne différentielle négative commune (O2), le premier port (P) de répartition comportant une première borne différentielle positive (P1) de répartition et une première borne différentielle négative (P2) de répartition, et le deuxième port (Q) de répartition comportant une deuxième borne différentielle positive (Q1) de répartition et une deuxième borne différentielle négative (Q2) de répartition ;

le premier réseau (31) de transmission de signaux comportant une première inductance (L1) et une deuxième inductance (L2), et le deuxième réseau (32) de transmission de signaux comportant une troisième inductance (L3) et une quatrième inductance (L4) ; et

une première extrémité de la première inductance (L1) et une première extrémité de la troisième inductance (L3) étant couplées de façon correspondante à la borne différentielle positive commune (O1) et à la borne différentielle négative commune (O2), et une deuxième extrémité de la première inductance (L1) étant couplée à une deuxième extrémité de la troisième inductance (L3) ; deux extrémités de la deuxième inductance (L2) étant couplées de façon correspondante à la première borne différentielle positive (P1) de répartition et à la première borne différentielle négative (P2) de répartition ; et deux extrémités de la quatrième inductance (L4) étant couplées de façon correspondante à la deuxième borne différentielle positive (Q1) de répartition et à la deuxième borne différentielle négative (Q2) de répartition.

**15.** Procédé d'exploitation du dispositif (100) de communication selon la revendication 14, le circuit (33) de réglage de mode étant en outre couplé au deuxième réseau (32) de transmission de signaux ; et le mode de fonctionnement du répartiteur/combineur (300) de puissance comportant en outre un troisième mode, le troisième mode étant tel que le premier réseau (31) de transmission de signaux est connecté ; et

le procédé d'exploitation du dispositif (100) de communication comportant :

en variante, à un même instant, la commande, par le circuit (33) de réglage de mode, du premier réseau (31) de transmission de signaux pour qu'il soit connecté, et la commande du deuxième réseau (32) de transmission de signaux pour qu'il soit déconnecté, de telle sorte que le répartiteur/combineur (300) de puissance entre dans le troisième mode.

Communication device 100
Wired communication system [150]
Wireless communication system [160]
External memory interface [120]
Internal memory [121]
Audio module [170]
Sensor module [180]
Processor [110]
Button [190]
Motor [191]
Indicator [192]
Cameras 1 to N [193]
Displays 1 to N [194]
SIM card interfaces 1 to N [195]
USB port [130]
Charging input
Charging management module [140]
Power management module [141]
Battery [142]

FIG. 1A

150/160
10
30
20
First radio frequency circuit
M1
Power division/combination network
Power divider/ combiner
M2
M2
Second radio frequency circuit
Second radio frequency circuit
Antenna
Antenna

FIG. 1B

300
O
Power divider
P
Q

FIG. 2A

300
P
Q
Power combiner
O

FIG. 2B

300
A
$Z_0$
P
$\sqrt{2}Z_0$
$Z_0$
O
R
$2Z_0$
$Z_0$
$\sqrt{2}Z_0$
Q
B

FIG. 2C

300
A
C
C
P
L
O
R
$2Z_0$
L
Q
C
C
B

FIG. 2D

300
A
31
First signal transmission network
P
O
Mode tuning circuit
33
Second signal transmission network
Q
B
32

FIG. 3A

300
A
31
First signal transmission network
P
O
Mode tuning circuit
33
Second signal transmission network
Q
B
32

FIG. 3B

300
A
31
First signal transmission network
P
33
34
O
Mode tuning circuit
Isolation circuit
Second signal transmission network
Q
B
32

FIG. 3C

300
A
31
First signal transmission network
+
O1
O
−
O2
Mode tuning circuit
Second signal transmission network
+
P1
−
P2
P
+
Q1
−
Q2
Q
B
32

FIG. 4

300
31
A
33
+
O1
O
−
O2
L1
L2
S1
L3
L4
+
P1
−
P2
P
+
Q1
−
Q2
Q
32
B

FIG. 5A

300
31
A
33
+
P1
L1
L2
S1
P
+
O1
C1
C4
–
P2
O
–
O2
+
Q1
L3
L4
Q
C2
C5
–
Q2
32
B

FIG. 5B

300
31
A
33
+
P1
L1
L2
S1
P
+
O1
C4
–
P2
O
C3
–
O2
+
Q1
L3
L4
Q
C5
–
Q2
32
B

FIG. 5C

300
31
A
33
L1
L2
S1
R1
+
P1
−
P2
P
O
+
O1
−
O2
S3
S4
L3
L4
+
Q1
R2
−
Q2
Q
32
B

FIG. 6A

300
31
A
33
L1
L2
C1
C4
S1
R1
+
P1
−
P2
P
O
+
O1
−
O2
S3
S4
L3
L4
C2
C5
+
Q1
R2
−
Q2
Q
32
B

FIG. 6B

300
31
A
33
L1
L2
C4
S1
R1
+
P1
−
P2
P
O1
+
O
O2
−
C3
S3
S4
+
Q1
L3
L4
C5
R2
−
Q2
Q
32
B

FIG. 6C

300
A
31
First signal transmission network
+
P1
−
P2
P
O1
+
O
Mode tuning circuit
33
O2
−
Second signal transmission network
+
Q1
−
Q2
Q
B
32

FIG. 7

300
31
A
33
+
P1
L1
L2
S1
P
O1
+
–
P2
O
O2
–
+
Q1
L3
L4
S2
Q
–
Q2
32
B

FIG. 8A

300
31
A
33
+
P1
L1
L2
C1
C4
S1
P
O1
+
–
P2
O
O2
–
+
Q1
L3
L4
C2
C5
S2
Q
–
Q2
32
B

FIG. 8B

300
31
A
33
+
P1
P
L1
L2
C4
S1
−
P2
O
+
O1
C3
−
O2
+
Q1
L3
L4
C5
S2
Q
−
Q2
32
B

FIG. 8C

300
31
A
33
+
P1
L1
L2
S1
R1
P
−
P2
O
+
O1
−
O2
S3
S4
+
Q1
L3
L4
S2
R2
Q
−
Q2
32
B

FIG. 9A

300
31
A
33
L1
L2
C1
C4
S1
R1
+
P1
P
−
P2
+
O1
O
O2
−
S3
S4
+
Q1
L3
L4
S2
C2
C5
R2
−
Q2
Q
32
B

FIG. 9B

300
31
A
33
L1
L2
S1
R1
+
P1
C4
P
−
P2
+
O1
O
C3
O2
−
S3
S4
+
Q1
L3
L4
S2
C5
R2
Q
−
Q2
32
B

FIG. 9C

First mode: Both a first branch A and a second branch B are connected

A
31
33
L1
L2
C1
C4
S1
R1
P1
P2
P
O1
O2
O
S3
S4
L3
L4
C2
C5
S2
R2
Q1
Q2
Q
32
B


FIG. 10

Second mode: A second branch B is connected

A
31
33
X2
L1
L2
C1
C4
S1
R1
+
P1
–
P2
P
+
O1
O
–
O2
X1
S3
S4
+
Q1
L3
L4
S2
R2
C2
C5
–
Q2
Q
X3
32
B

FIG. 11

Third mode: A first branch A is connected

A
31
33
X2
L1
L2
C1
C4
S1
R1
+
P1
P
−
P2
+
O1
O
−
O2
X1
S3
S4
+
Q1
L3
L4
S2
R2
Q
C2
C5
−
Q2
X3
32
B

FIG. 12

First mode: Both a first branch A and a second branch B are connected

A
31
33
+
P1
P
L1
L2
S1
R1
C1
C4
−
P2
O1
+
O
O2
−
S3
S4
+
Q1
L3
L4
S2
R2
Q
C2
C5
−
Q2
32
B

FIG. 13

Second mode: A second branch B is connected

A
31
33
X2
L1
L2
C1
C4
S1
R1
+
P1
−
P2
P
+
O1
O
−
O2
X1
S3
S4
+
Q1
L3
L4
S2
R2
C2
C5
−
Q2
Q
X3
32
B

FIG. 14

Third mode: A first branch A is connected

A
31
33
X2
L1
L2
C1
C4
S1
R1
+
P1
P
−
P2
O
+
O1
−
O2
X1
S3
S4
+
Q1
L3
L4
S2
R2
C2
C5
Q
−
Q2
X3
32
B

FIG. 15

300
31
A
33
L5
C6
C7
S1
L6
P1
P2
P
O1
O2
O
L7
C8
C9
L8
Q1
Q2
Q
32
B

FIG. 16A

300
31
A
33
L5
C6
C7
S1
P1
P2
P
L6
O1
O
O2
L7
C8
C9
S2
Q1
Q2
Q
L8
32
B

FIG. 16B

300
31
A
33
L5
C6
C7
S1
R1
P1
P2
P
L6
O1
O
O2
S3
S4
L7
C8
C9
Q1
R2
Q2
Q
L8
32
B

FIG. 16C

300
31
A
33
L5
C6
C7
L6
S1
R1
+
P1
−
P2
P
+
O1
O
−
O2
S3
S4
L7
C8
C9
L8
S2
R2
+
Q1
−
Q2
Q
32
B

FIG. 16D

300
31
A
33
L1
L2
C1
C4
S1
R3
P1
P2
P
+
−
O1
O2
O
S5
L3
L4
C2
C5
S2
Q1
Q2
Q
32
B

FIG. 17A

300
31
A
33
L5
C6
C7
L6
S1
R3
P1
P2
P
+
−
O1
O2
O
S5
L7
C8
C9
L8
S2
Q1
Q2
Q
32
B

FIG. 17B

300
31
A
33
L1
L2
C1
C4
S1
P1
P2
P
R3
O
O1
O2
S5
L3
L4
C2
C5
S2
Q1
Q2
Q
32
B

FIG. 17C

300
31
A
33
L5
C6
C7
S1
P1
P2
P
L6
R3
O
O1
O2
L7
S5
C8
C9
S2
Q1
Q2
Q
L8
32
B

FIG. 17D

30
300
300
300
P
Q
P1
P2
Q1
Q2
S1
S2
S3
S4
R1
R2
C1
C2
C4
C5
L1
L2
L3
L4
P1 (O1)
P2 (O2)
Q1 (O1)
Q2 (O2)
O
O1
O2

FIG. 18A

30
300
O (M1)
P (M2)
Q (M2)

FIG. 18B

30
300
O (M1)
P (O)
Q (O)
P (O)
Q (M2)
P (O)
Q (M2)
P (M2)
Q (M2)
P (M2)
Q (M2)
P (M2)
Q (M2)
P (M2)
Q (M2)

FIG. 18C

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description


- US 2019081399 A1
- US 2010311339 A1
- CN 101478291 A